# EUROPEAN PATENT SPECIFICATION

(11) **EP 2 101 357 B1**
(45) Date of publication and mention of the grant of the patent: **20.11.2013**
(21) Application number: 09003514.8
(22) Date of filing: 11.03.2009
(51) Int. Cl.: H01L 31/042, H01L 31/05, H01L 31/18, H01L 27/142, G01R 31/40

(54) **Solar energy module having repair line, solar energy assembly having the same, method of repairing the solar energy module and method of trimming the solar energy assembly**
Solarmodul mit Reparaturleitung, Solaranordnung mit diesem Modul, Verfahren zum Reparieren des Solarmoduls und Verfahren zum Justieren der Solaranordnung
Module d'énergie solaire disposant d'une ligne de réparation, ensemble d'énergie solaire en disposant, procédé de réparation du module d'énergie solaire et procédé de réglage de l'ensemble d'énergie solaire

(30) Priority: 12.03.2008 KR 20080022800; 23.01.2009 KR 20090006188
(43) Date of publication of application: 16.09.2009
(73) Proprietor: Samsung Electronics Co., Ltd., Suwon-si, Gyeonggi-do, 443-742 (KR); SAMSUNG SDI CO., LTD., Yongin-si, Gyeonggi-do (KR)
(72) Inventor: Shin, Myung-Hun, Suwon-si, Gyeonggi-do (KR); Choi, Dong-Uk, Seoul (KR); Kim, Byoung-June, Seoul (KR); Kim, Jin-Seock, Cheonan-si Chungcheongnam-do (KR); Lee, Czang-Ho, Hwaseong-si, Gyeonggi-do (KR); Jung, Seung-Jae, Seoul (KR); Seo, Joon-Young, Seocho-gu (KR)
(74) Representative: Taor, Simon Edward William

(56) References cited:
- JP-A- 2005 135 941
- US-B1- 6 288 323

## Description

The present disclosure of invention relates to a solar energy module, a solar energy assembly having the solar energy module, a method of repairing the solar energy module and a method of trimming the solar energy assembly. More particularly, the disclosure relates to a solar energy module which includes unit cells of a thin-film type.

Generally, a solar energy module of a thin-film type (e.g., amorphous silicon) includes a plurality of unit cells which are connected in series with each other where each operative unit cell generates electrical energy at a respective voltage in response to absorbed solar radiation. The unit cells may be integrally formed on a glass substrate through an integrated circuit batch process.

When one of the series-connected unit cells of the integrated solar energy module experiences a full or partial loss of function due for example to a short circuit or a disconnection or a drop in output voltage, the performance and/or lifetime of the solar energy module may become degraded.

Thus, a solar energy module having a defect such as mentioned above may not be suitable for use in fields requiring long term reliability. For example, even after manufacture of an almost fully operable module but with one defective cell (or but with a short run burst of defects such as in a few immediately-adjacent-to-each-other cells), the entire solar energy module may become unusable for its intended purpose and may have to be discarded despite the fact that it contains a substantially large number of good cells. On the other hand, if an efficient method of detecting defects and repairing the solar energy module can be devised, it may be possible to avoid the need for discarding an entire solar energy module due to only a single cell defect or a spot-like defect wherein just a few close together cells are defective.

In view of the general requirement imposed on mass production lines to produce modules of substantially same performance and of good long term reliability, uniformity among solar energy modules is important. As mentioned, the unit cells of the solar energy module are conventionally connected in series with each other. A solar energy assembly typically includes a plurality of such solar energy modules which are connected in parallel with each other so that their currents may be summed. If the module output voltages of each of the solar energy modules are not uniformly essentially the same, the long-term reliability of the solar energy modules may be decreased due to large short circuiting currents flowing among the parallel-wise connected circuits that have substantially different output voltages.

When a same mass production process is performed on a given integrated substrate, the output voltages of each of the unit cells on that one substrate tend to be nearly the same as each other. About 50 to 100 of the unit cells are typically connected in series with each other on the integrated substrate to form the integrated solar energy module.

The output voltage of each of the unit cells has a variation of about ±5% due to variations in the manufacturing process. This variation of the output voltage of a single unit cell may be very small, however, the variation of the output voltage of a large number of unit cells (in other words, of a module) may be on the order about several volts.

Typically, the solar energy modules are connected in parallel in an electrical power generation system. Thus, it is desirable for the module output voltages to be uniform with one another for long-term reliability. Accordingly, in addition to a method of repairing when defective unit cells are present, a method for preventing or controlling the variations of the parallel-wise connected solar energy modules is desired.

US 6,288,323 discloses a series connected array of thin film photoelectric commission cells.

### SUMMARY

According to the present invention there is provided a solar energy module according to Claim 1, a solar energy assembly according to Claim 16, a method of preparing or trimming a solar energy module according to Claim 27 and a method of training a solar energy assembly according to Claim 36.

The present disclosure provides a monolithically integrated solar energy module in which repair may be easily effected for individual defective unit cells or for groups of defective unit cells and/or in which individual module voltage output may be easily trimmed to match a predefined reference voltage.

Example embodiments of the present disclosure also include a solar energy assembly including a plurality of solar energy modules connected in parallel to one another.

Example embodiments of the present disclosure also include a method of repairing a solar energy module having one or more defective cells.

Example embodiments of the present disclosure also include a method of trimming modules in the solar energy assembly so that they are substantially matched with one another.

A solar energy module of an embodiment includes a plurality of unit cells that are connected in series and an integrated bypass line extending alongside the series of unit cells. Each unit cell includes a set of integrated electrode layers, a set of one or more integrated semiconductor layers and an integrated repair pad. The set of integrated electrode layers includes a lower electrode layer and a spaced apart upper electrode layer facing the lower electrode layer. The set of semiconductor layers is disposed between the lower electrode layer and the upper electrode layer and defines a photo-electric converter that converts photonic energy into electrical energy. The repair pad is electrically connected to the electrode layer and protrudes toward one side of the cell unit. An electrode layer of a first unit cell is electrically connected to an electrode layer of a next adjacent unit cell, if any, so that the successive unit cells are thereby connected in series with each other. The bypass line is disposed closely adjacent to a plurality of the repair pads so as to function for each unit cell as said other adjacent structure to which the respective repair pad of the unit cell may be connected.

A solar energy assembly of an embodiment includes a plurality of solar energy modules, a first output line and a second output line. Each of the solar energy modules includes an array of successively connected unit cells, a first bypass line and a second bypass line. Each of the unit cells includes a set of electrode layers including a lower electrode layer and an upper electrode layer facing each other, a set of one or more semiconductor layers disposed between the lower electrode layer and the upper electrode layer, and a repair pad being electrically connected to an electrode layer of the set of electrode layers and protruding outwardly from one side of the unit cell. The upper electrode layer of a first unit cell is integrally connected to a lower electrode layer of a next adjacent unit cell, if any, so that the unit cells are integrally connected in series with each other. The first bypass line extends adjacent to the repair pad of the unit cell corresponding to a high-voltage output of the array. The second bypass line extends adjacent to the repair pad of the unit cell corresponding to a low-voltage output of the array where the difference between the high and low voltages is substantially equal to a pre-defined reference voltage. The first output line connects the respective repair pads corresponding to the high-voltage output of the solar energy modules in parallel with each other. The second output line connects the respective repair pads corresponding to the low-voltage output of the solar energy modules in parallel with each other.

In a method of an embodiment of repairing or trimming the solar energy module, where the solar energy module includes an array of successive unit cells, and where an upper electrode layer which is disposed on a corresponding one or more semiconductor layers of each unit cell is electrically connected to a lower electrode layer under semiconductor layers of a next adjacent unit cell along a first direction so that the successive unit cells are connected in series with each other, the method includes at least one of performing a first bypassing and performing a second bypassing. The first bypassing includes connecting repair pads extending from electrode layers of a first unit cell and a second unit cell to a bypass line so that one or more unit cells including the first unit cell or the second unit cell are bypassed. The second bypassing includes directly connecting repair pads of a third unit cell and a fourth unit cell with each other so that at least one of the third unit cell and the fourth unit cell is bypassed.

In a method of an embodiment of trimming a solar energy assembly including a plurality of solar energy modules, each of the solar energy modules includes an array of successive unit cells. An upper electrode layer which is disposed on a corresponding one or more semiconductor layers of each unit cell where the semiconductor layers define a photo-electric converter, and the upper electrode layer of a first of the cells is electrically connected to a lower electrode layer under semiconductor layers of a next adjacent unit cell along a first direction, so that the successive unit cells are thereby connected in series with each other. A reference output voltage for the solar energy modules is defined as a voltage which is to be substantially output by all for the solar energy modules of the assembly where necessary bypassing one or more cells in each repairing each of the solar energy modules so as to thereby cause each to have the reference output voltage. Respective voltage outputs of the solar energy modules are connected parallel with each other by using output lines of the solar energy modules.

According to a further example embodiment, when a defective unit cell is detected after forming a solar energy module by forming a thin film during a mass production process, the defective unit cell may be bypassed so that the yield of operable modules may be increased.

In addition, the module output voltage may become uniform so that the reliability of the module may be increased when combined with other modules.

### BRIEF DESCRIPTION OF THE DRAWINGS

The above and other features and advantages of the present disclosure of invention will become more apparent by describing in detailed example embodiments thereof with reference to the accompanying drawings in which:

FIG. 1 is a plan view illustrating a solar energy module in accordance with an embodiment;

FIG. 2 is a cross-sectional view illustrating the solar energy module taken along a line I-I' in FIG. 1;

FIG. 3 is a cross-sectional view illustrating the solar energy module taken along a line II-II' in FIG 1;

FIG. 4 is an equivalent circuit diagram for the unit cell in FIG. 2;

FIG. 5 is a flowchart illustrating a method of repairing the solar energy module in accordance with a first embodiment;

FIG. 6 is a cross-sectional view illustrating an example method of testing the unit cell for defects;

FIG. 7 is a cross-sectional view illustrating another example method of testing the unit cell for defects;

FIG. 8 is a graph of a current generated from the unit cell in relation to a test voltage applied to the unit cell as illustrated in FIGS. 6 and 7;

FIG. 9 is a plan view of the solar energy module repaired according to one or more methods described in FIGS. 5 and 9;

FIG. 10 is an equivalent circuit diagram illustrating the solar energy module in FIG. 9;

FIG. 11 is a plan view illustrating a first embodiment of a solar energy assembly in accordance with the disclosure;

FIG. 12 is an equivalent circuit diagram illustrating the solar energy assembly in FIG. 11;

FIG. 13 is a flowchart illustrating a method of trimming the solar energy assembly of Fig. 11;

FIG. 14 is a plan view illustrating a solar energy assembly including solar energy modules which may be trimmed to have substantially the same module output voltages as each other;

FIG. 15 is an enlarged view illustrating a first area, A in FIG. 14;

FIG. 16 is a plan view illustrating a second embodiment of a solar energy module in accordance with the disclosure;

FIG. 17 is a plan view illustrating a solar energy assembly including solar energy modules which may be trimmed to have substantially the same module output voltage as each other in accordance with a second embodiment;

FIG. 18 is an enlarged view illustrating a second area, B in FIG. 17;

FIG. 19 is a plan view illustrating a solar energy module in accordance with another example embodiment;

FIG. 20 is a cross-sectional view illustrating the solar energy module taken along a line III-III' in FIG. 19;

FIG. 21 is a plan view illustrating a solar energy module in accordance with still another example embodiment;

FIG. 22 is a flowchart illustrating method of repairing the solar energy module in FIG. 21; and

FIG. 23 is a plan view illustrating a solar energy module in accordance with a fifth embodiment.

### DETAILED DESCRIPTION

Although teachings of the present disclosure are described more fully hereinafter with reference to the accompanying drawings, the underlying concepts may, however, be embodied in many different forms and should not be construed as limited to the exemplary embodiments set forth herein. Rather, these exemplary embodiments are provided so that this disclosure will be thorough and complete, and will fully convey its teachings to those skilled in the pertinent art. In the drawings, the sizes and relative sizes of layers and regions may be exaggerated for sake of clarity.

It will be understood that when an element or layer is referred to as being "on," "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular exemplary embodiments and is not intended to be limiting of the present disclosure. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Exemplary embodiments are described herein with reference to cross-sectional illustrations that are schematic illustrations of idealized example embodiments (and intermediate structures) of the present invention. As such, variations from the shapes of the illustrations as a result, for example, of manufacturing techniques and/or tolerances, are to be expected. Thus, example embodiments herein should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of the present invention.

Unless otherwise defined, all terms (including technical and scientific terms) used herein have the same meaning as commonly understood by one of ordinary skill in the pertinent art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, the present disclosure of invention will be explained in detail with reference to the accompanying drawings.

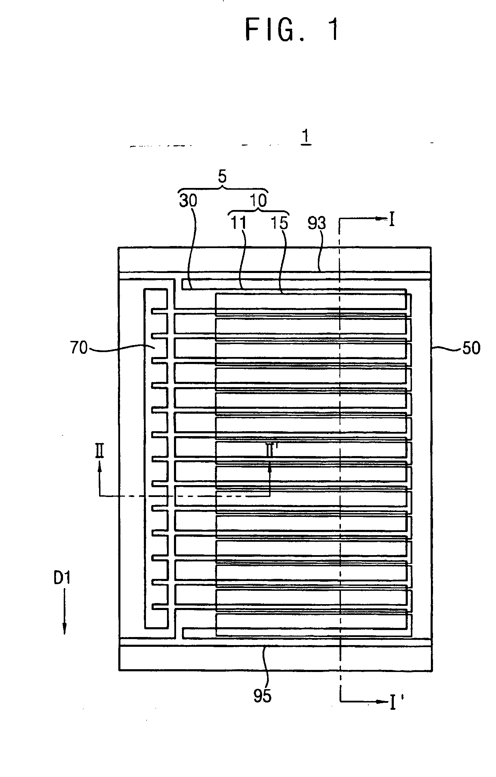

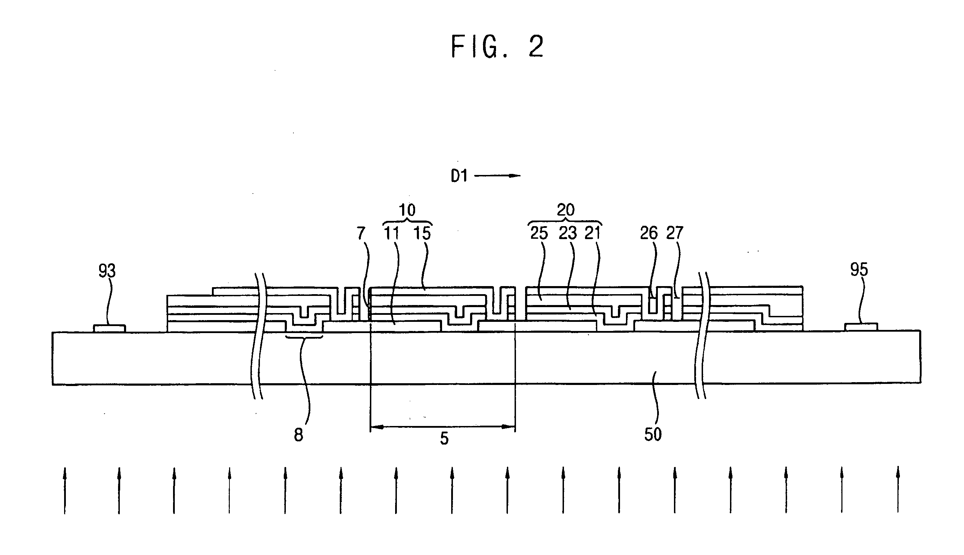

FIG. 1 is a plan view illustrating a solar energy module 1 in accordance with a first embodiment. FIG. 2 is a cross-sectional view illustrating the solar energy module 1 taken along a line I-I' in FIG. 1.

Referring to FIGS. 1 and 2, the solar energy module 1 includes a plurality of horizontally extending unit cells 5 and a vertically extending bypass line 70, both integrally formed on a monolithic substrate 50.

Operative normal ones of the unit cells 5 can generate electrical power in response to externally supplied incident light such as the solar light shown entering from the bottom of the electrically-insulating and light-passing substrate 50 in Fig. 2. As seen in Fig. 1, the horizontal unit cells 5 are disposed one after another along a first vertical direction D1 (vertical in Fig. 1) and they are initially all electrically connected in series with each other along that first direction D1. In the illustrated exemplary embodiment, the solar energy module 1 is formed of a thin film construct (e.g., it uses thin films of amorphous silicon as its active layer). Thus, the solar energy module 1 includes a light passing (e.g., transparent) and electrically insulating substrate 50 such as a glass substrate or a plastic one or a combination of both.

Each of the unit cells 5 includes a set of electrodes referenced as 10 and disposed on the substrate 50, a plurality of semiconductor layers referenced as 20 and a local repair pad 30 (where the lead line of reference number 30 terminates at the top edge of the repair pad in Fig. 1).

The electrode set 10 includes a lower electrode layer 11 and an upper electrode layer 15 (where the respective lead lines of reference numbers 11, 15 terminate at the top edges of the respective lower and upper electrode layers in Fig. 1).

As seen in Fig. 2, the lower electrode layer 11 is formed on an upper face of the substrate 50 and may be formed of transparent and electrically conductive materials, for example, one or more transparent conductive oxides (TCO's, e.g., ITO, IZO, etc.).

The upper electrode layer 15 is disposed above the lower electrode layer 11 and facing the lower electrode layer 11. The upper electrode layer 15 may be formed to include a light reflecting metal (e.g., reflective aluminum). Thus, the upper electrode layer 15 may function as a light reflecting electrode.

The set of semiconductor layers 20 is disposed between the lower electrode layer 11 and the upper electrode layer 15. The semiconductor layers set 20 can generate an electromotive force (e.g., a voltage) in response to absorbed incident light such as solar light transmitted through the substrate 50 and through the lower electrode layer 11. An electric field may be formed between the lower electrode layer 11 and the upper electrode layer 15 due to the electromotive force, so that an electric current may be generated by the unit cells 5 when connected to an appropriate load.

The type of semiconductors used in layer 20 may be varied. For example, the illustrated set of semiconductor layers 20 may define a PIN junction diode. Such a PIN diode may be formed by stacking a P-type semiconductor layer 21 (e.g., a-Si), an intrinsic (I-type) semiconductor layer 23 and an N-type semiconductor layer 25 according to this recited order to form the semiconductor layers set 20. (Although not explicitly shown in Fig. 2, it is understood that vertical sidewall faces (e.g., 7) of the stacked semiconductor layers (e.g., 21=P, 23=I, 25=N) are insulated for example by a thin oxide (not shown) so as to prevent shorting through adjacent vertical sides of electrodes 11 and 15.) Since the semiconductor layers set 20 may define an optical absorption diode which absorbs light and responsively generates an electrical voltage and/or current, a unit cell 5 is formed. The currents and/or voltages generated by the respective unit cells 5 may be collected through output lines which are connected to selected ones of the lower electrode layers 11 and the upper electrode layers 15, respectively.

The electrode set 10 and the semiconductor layers set 20 may be formed on the substrate 50 by using thin-film deposition processes. A cell-to-cell separation space 27 may be formed through the upper electrode layer 15 and through the semiconductor layers set 20, where separation space 27 is periodically repeated along the D1 direction as illustrated in FIG. 2. The unit cells 5 are thus separated from each other by the cell-to-cell separation spaces 27. First insulating sidewalls (not shown) may be formed on the inside walls of each cell-to-cell separation spaces for providing electrical insulation.

In one embodiment, each of the unit cells 5 may have a width about 1 cm (as measured in the D 1 direction of Fig. 2) and a length about 1 m or more (in other words, an aspect ratio of about 1:100 or more). Thus, each of the unit cells 5 may have the shape of an elongated rectangle or bar as seen in Fig. 1. The unit cells 5 are electrically connected in series with each other along the first direction D1 which is substantially perpendicular to the longitudinal axes of the unit cells 5.

For example, the upper electrode layer 15 of a first of the unit cells 5 may be electrically connected to the lower electrode layer 11 of an adjacent second of the unit cells 5 along the first direction D1 as is schematically illustrated in FIG. 2. Each contact hole 26 is formed through the semiconductor layers set 20, so that the lower electrode layer 11 is partially exposed at the bottom of the otherwise insulated contact hole 26 (into which hole, electrode layer 15 descends). The upper electrode layer 15 of the adjacent unit cell 5 extends down to the bottom of the contact hole 26 so as to be electrically connected to the lower electrode layer 11 of the next cell along the D1 direction (to its right as shown in Fig. 2). Prior to deposition of layer 15, insulating sidewalls (not shown) may be formed on the insides of each contact hole 26 so as to thereby insulate the semiconductor layers set 20 from the portion of the upper electrode layer 15 that descends down into contact hole 26.

An electrode separation gap 8 is formed between the adjacent lower electrode layers, for example by use of sidewall insulating material. The semiconductor layers set 20 may extend into the electrode separation gap 8 without making sidewall contact with the adjacent lower electrodes 11 and 11' (the prime indicating the next cell in the D1 direction). Gap insulating layers (not shown) may be formed on inside of each electrode separation gap 8 to insulate the semiconductor layers set 20 and the lower electrode 11 between the adjacent unit cells 5.

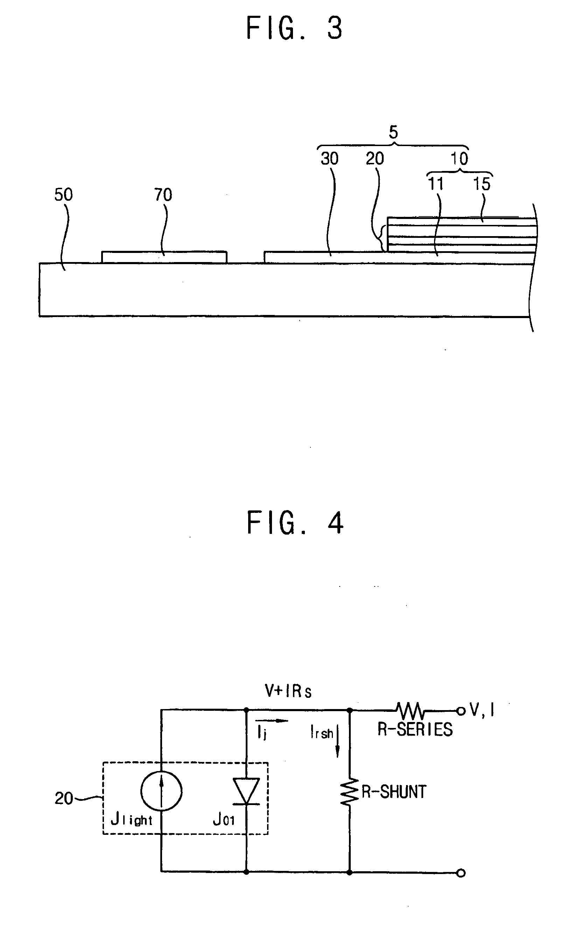

FIG. 3 is a cross-sectional view illustrating the solar energy module 1 taken along a line II-II' in FIG. 1.

Referring to FIGS. 1 to 3, the repair pad 30 protrudes from the electrode set 10 along the cell's longitudinal axis toward one side of the unit cell 5. In this example embodiment, the repair pad 30 is integrally formed seamlessly with, or is otherwise electrically connected to the lower electrode layer 11. The repair pad 30 extends beyond the lower electrode 11 along the cell's longitudinal axis direction and thus protrudes in an exposed manner from the end portion of the unit cell 5. The lower electrode layer 11 and the repair pad 30 may be formed from a same material (e.g., ITO, IZO, etc.). The repair pads 30 of two adjacent cells may be used to bypass (e.g., short out) a single defective unit cell 5 among the adjacent cells and to thus provide a repair for the defect. Here, "to repair a defect" refers to creating a cell-bypassing closed circuit connection around the defective unit cell 5 while leaving the rest of the array of the unit cells 5 connected to each other in series and thus allowing the remaining nondefective cells to operate in series while electrically bypassing the defective (e.g., open) unit cell 5.

The aforementioned bypass line 70 is formed closely adjacent to, but spaced apart from the plurality of repair pads 30 of the respective unit cells 5. The bypass line or conductor 70 may extend along the first direction D1 (vertical in Fig. 1) and may include narrow sections as well as wide sections as shown in Fig. 1. When a defective unit cell 5 is disposed in an identified row, the integrated bypass line 70 may be used to bypass the row of the identified defective unit cell 5.

The bypass line 70 and the repair pads 30 may be formed on the same layer or on different layers of the substrate 50. When the bypass line 70 and the repair pads 30 are formed on the same layer, repair processes for the defective unit cell 5 may become more efficient.

The solar energy module 1 may further include a first module output line 93 and a second module output line 95. The first output line 93 (where the lead line of reference number 93 terminates at the top edge of the first module output line in Fig. 1) is integrally connected to the module's topmost repair pad 30, where the latter corresponds to a maximum high-voltage output of the solar energy module 1. The second module output line 95 (where the lead line of reference number 95 terminates at the bottom edge of the second module output line in Fig. 1) is integrally connected to the module's lowermost repair pad 30 where the latter corresponds to a lowest output voltage (e.g., ground or negative) of the solar energy module 1.

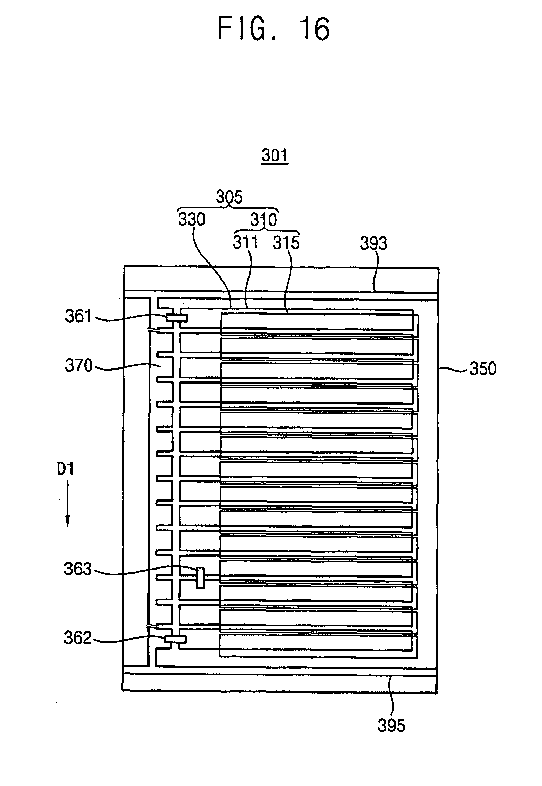

The probability that the topmost unit cell 5 and/or the bottom most unit cell 5 respectively disposed on the ends of the array of the unit cells 5 will be defective is relatively small. Thus, in one embodiment, the first output line 93 and the second output line 95 may be directly connected to the repair pads 30 of the top unit cell 5 and the bottom unit cell 5 respectively rather than through the bypass line 70. (In an alternate embodiment, e.g., that of Fig. 16, the vertical bypass line 70 is directly connected to the top and bottom module output lines, 393, 395 and cuts are made into the vertical bypass line 70 at the points where it is strap-wise connected to a topmost and bottommost cell of the array.)

FIG. 4 is an equivalent circuit diagram for the unit cell 5 in FIG. 2 and is used for explaining some of the different kinds of defects that may occur.

Referring to FIG. 4, the semiconductor layers set 20 is represented as the optical absorption diode 20 which absorbs light and generates a corresponding electromotive force resulting in the production of current J_{Light}. The same reference number 20 is used for the optical absorption diode 20 and the semiconductor layers 20.

A contact series resistor, R-series is effectively formed at an interface between the lower electrode layer 11 and the P-type semiconductor layer 21 and/or at an interface between the upper electrode layer 15 and the N-type semiconductor layer 25. The contact resistor, R-series is an internal resistance of the unit cell 5 and is thus connected in series with the idealized optical absorption diode 20 as illustrated in FIG. 4.

The cell generated voltage which appears between the lower electrode layer 11 and the upper electrode layer 15 may have a lower voltage level (V) than that of the internal electromotive force (V + IR) produced by the diode 20 due to the ohmic drop (I*R) of the contact resistor, R-series. In addition, a first current Ij outputted from the internal diode 20 will be increased when the resistance of the contact resistor R-series is decreased and diode voltage remains unchanged. The resistance of the contact resistance, R-series of a normal unit cell 5 may be very small. However, a defective cell may have a substantially greater contact resistor, R-series which disadvantageously impedes flow of series current through the series connected array of plural diodes.

A portion of the ideal current, I_{J} generated by each ideal diode 20 may fail to be drawn out at the output terminal (V, I) and instead may be lost as shunt loss current Iᵣₛₕ through a parasitic shunt resistance, Rₛₕᵤₙₜ. For example, a portion of the generated current may be leaked along cell side faces 7 of the cell-to-cell separation space 27 and may be leaked along the electrode separation gap 8 as illustrated in FIG. 2.

The resistance of the effective shunt resistance (R-shunt) in good cells may be very large, so that loss due to this mechanism is substantially negligible. As seen in Fig. 4, this loss mechanism is referred to as a leakage resistor R-shunt and the leakage resistor R-shunt is connected in parallel with the optical absorption diode 20.

When the resistance of the leakage resistor R-shunt is very large (as it should be in a normal unit cell 5), the cell output current I is substantially the same as the ideal current I_{J} output by the optical absorption diode 20.

In accordance with an example embodiment, each repair pad 30 extends from the lower electrode layer 11 toward one side of the respective unit cell 5 and toward the bypass line 70 where the vertical bypass line 70 is disposed to be closely adjacent to and normally spaced apart and insulated from the repair pads 30, but where the spacing may be conveniently closed by one or more means so as to thereby connect the unit cell 5 to the adjacent bypass line 70. By cutting the bypass line 70 in appropriate places and/or connecting the bypass line 70 to adjacent repair pads 30 in appropriate places, a repair processes may be optionally performed for one or more defective unit cells 5 of the integrated module, so that the mass production yield of usable solar energy modules 1 may thereby be increased.

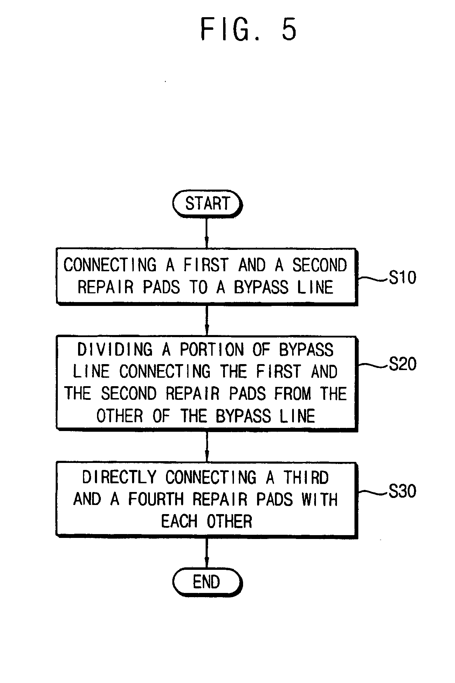

FIG. 5 is a flowchart illustrating an exemplary method of repairing the solar energy module in accordance with a first embodiment by using the repair pads 30 and/or the adjacent bypass line 70.

Referring to FIG. 5, in this embodiment, the method of repairing the solar energy module may be used in repairing the solar energy module 1 of FIGS. 1 to 4. In the method of repairing, at least one of a first bypassing and a second bypassing is performed. The performing order for the first bypassing and the second bypassing may be varied and repeated as deemed appropriate.

In the optional first bypassing step S10, the repair pads 30 of a first unit cell 5 and a second unit cell 5 are connected to the bypass line 70 so that one or more unit cells 5 including at least one of the first unit cell 5 or the second unit cell 5 are bypassed (step S10).

First, before bypassing is implemented, each unit cell 5 is inspected to determine if the unit cell 5 is a defective unit cell 5. A defective unit cell 5 may be deemed as such if it fails to have desired properties substantially close to that of the ideal optical absorption diode 20 and its associated series and shunt resistances (Rₛₑᵣᵢₑₛ, Rₛₕᵤₙₜ). Inspection and determination may be carried out by automated means such as by automated test equipment (ATE) with appropriate computer software controlling the inspection and the subsequent repair process if needed.

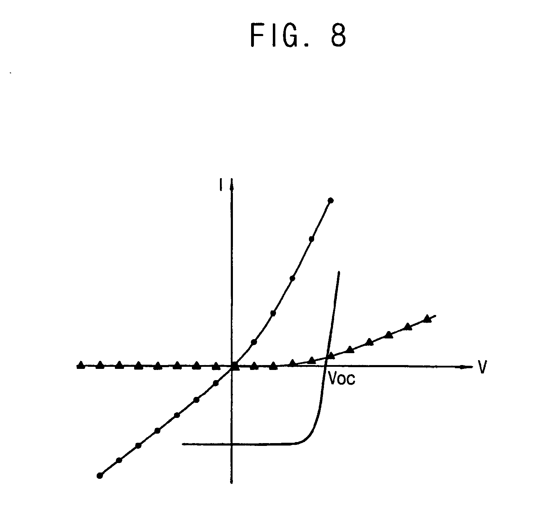

One method by which it may be determined whether a given unit cell 5 has any defects or not is by determining whether an I versus V graph (see Fig. 8) for that cell shows a current outputted from the unit cell 5 in relation to a potential difference formed between the lower electrode layer 11 and the upper electrode layer 15 as substantially following a desired rectification graph of a current in relation to voltage for an ideal diode 20 or not.

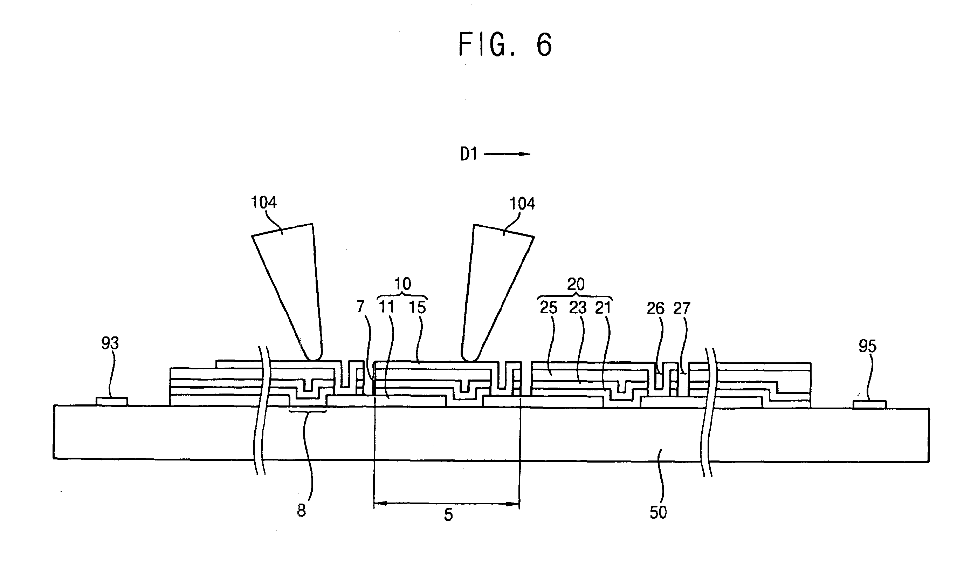

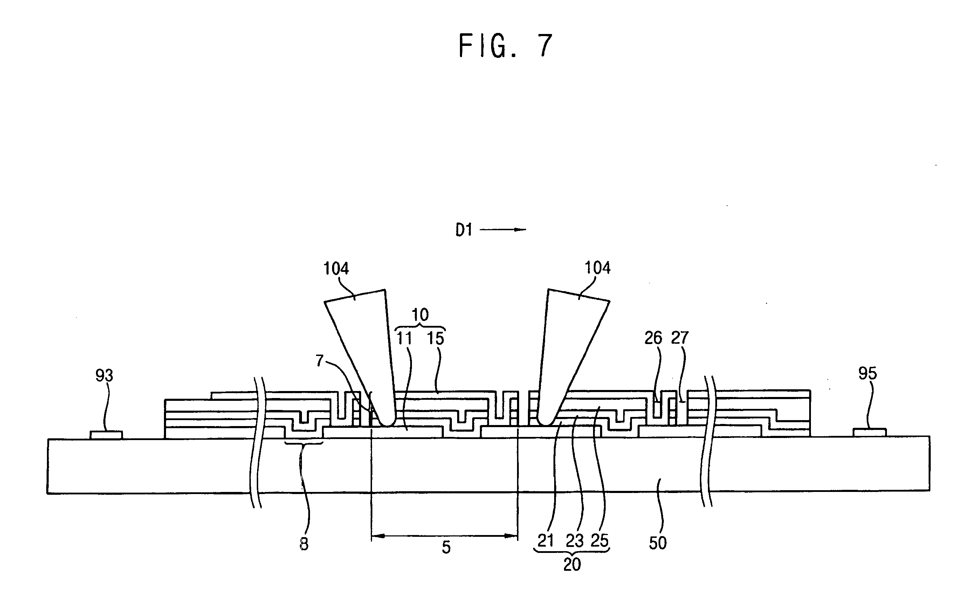

FIG. 6 is a cross-sectional view illustrating a first example method of testing a corresponding unit cell 5 for defects. FIG. 7 is a cross-sectional view illustrating another example method of testing the unit cell 5 for defects.

Referring to FIGS. 6 and 7, a set of probes 104 may be used to test the unit cell 5. For example, the probes 104 are contacted with the upper electrode layers 15 adjacent to each other, respectively, and a varied test voltage (V) may be applied between the upper electrode layers 15 as illustrated in FIG. 6 while resulting current (I) is measured (or vise versa).

Alternatively, the probes 104 are contacted with the lower electrode layers 11 (e.g., to pads 30) adjacent to each other, respectively, and the test voltage may be applied to the lower electrode layers 11 as illustrated in FIG. 7.

The upper electrode layer 15 of one of the unit cells 5 of the solar energy module 1 illustrated in FIGS. 1 to 4 is electrically connected to the lower electrode layer 11 of another one of the unit cells 5 adjacent to the one of the unit cells 5 along the first direction D1. Thus, when the time varied or discretely sampled test voltages are applied to the unit cell 5 as illustrated in FIGS. 6 and 7, the test voltage is applied to the lower electrode layer 11 and the upper electrode layer 15 of the same unit cell 5.

FIG. 8 shows a variety of possible graphs of a measured current I passing through the unit cell 5 in relation to an applied and changed test voltage V applied to the unit cell 5 as illustrated in FIGS. 6 and 7.

Referring to FIGS. 4 and 8, when the resistance of the contact resistance R-series of the unit cell 5 is very small and the resistance of the leakage resistance R-shunt is very large, the unit cell 5 is regarded as a normal unit cell 5. In the normal unit cell 5, when output voltage V exceeds a critical or threshold voltage Voc, a positive and large output current I is outputted from the unit cell 5. A normal rectification graph of a current (I) in relation to voltage (V) of a diode 20 as illustrated with a solid un-dotted line in FIG. 8 may be obtained from the normal unit cell 5. This normal rectification graph may be made without supplying light to the tested cell and instead merely determining what the forward bias threshold voltage Voc of the cell is and what the reverse bias current is, as well as what I versus V curve looks like at other sample points in the I versus V plane.

A curve marked with triangle dots in FIG. 8 is a characteristic curve of current in relation to the voltage of the unit cell 5, which is obtained when the resistance of the contact resistor R-series is larger than a predefined limit, so that the unit cell 5 loses the characteristics of an ideal diode 20. An abnormal curve of a current in relation to voltage of the unit cell 5 as mentioned above shows up when the contacts between the lower electrode layer 11 and the semiconductor layer 20 and between the upper electrode layer 15 and the semiconductor layer 20 are not good. The loss of current output (I) versus test voltage (V) applied is due to the large resistance of the contact resistor R-series, so that an output current of the defective unit cell 5 is much smaller than that of the normal unit cell 5 with output voltages of the defective unit cell 5 and the normal unit cell 5 being the same.

A curve marked with circle dots in FIG. 8 is a characteristic curve of a current in relation to the voltage of the unit cell 5, which is obtained when the resistance of the leakage resistance R-shunt is smaller than a respective predefined limit, so that the unit cell 5 loses the characteristics of an ideal diode 20 and appears to function more like just a linear resistor rather than a nonlinear diode. Referring to FIG. 4, when the resistance of the leakage resistor R-shunt is smaller than the limit, although the output voltage V of the defective unit cell 5 is smaller than the critical voltage Voc, a relatively large current may flow between the lower electrode layer 11 and the upper electrode layer 15, so that the unit cell 5 loses the characteristics of an ideal diode 20 that blocks current flow when operating below V_{OC}.

When a defective unit cell 5 is detected, the electrodes 10 of the defective unit cell 5 may be electrically shorted to one another in one embodiment, for example by connecting nearby repair pads to the bypass line 70 or directly shorting the repair pads 30.

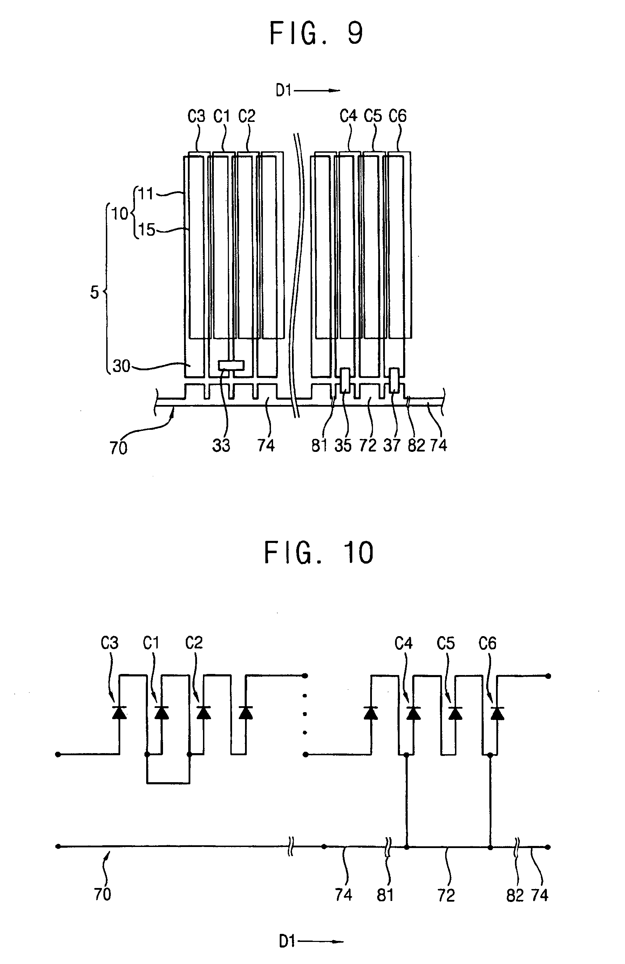

FIG. 9 is a plan view of the solar energy module 1 repaired according to one or more methods described in FIGS. 5 and 9.

Referring to FIG. 9, in this exemplary embodiment, when a first defective unit cell, say C4, is next adjacent to a second defective unit cell, say C5, the repair pad 30 extending from the lower electrode 11 of the first defective unit cell C4 is connected to the bypass line 70 and the repair pad 30 extending from the lower electrode 11 of the next non-defective unit cell, C6 is connected to the bypass line 70. For example, as part of such a defects bypassing process, a first bridge 35 is formed to connect the repair pad 30 of the first defective unit cell C4 to the bypass line 70. The first bridge 35 may partially overlap with the selected repair pad 30 and the bypass line 70. The first bridge 35 may be formed for example by soldering or by other space closing conductive means. A second bridge 37 is similarly formed to connect the repair pad 30 of the non-defective unit cell C6 to the bypass line 70.

In the above example, two normal unit cells are connected to the bypass line 70; namely, the normal cell C6 immediately following the sequence of defective cells, C4 and C5; and the normal cell (to the left of C4) immediately preceding the sequence of defective cells, C4 and C5. Thus, the bypass line 70 or a selectively cut-out portion 72 thereof, bypasses the defective cells while linking the normal cells together.

In the exemplary first bypassing, finally, a portion 72 of the bypass line 70 which connects the defective unit cell C4 to the normal unit cell C6 is divided (by cut 81) from the other portion 74 of the bypass line 70 so that the defective unit cells are bypassed (step S20).

For example, the portion 72 of the bypass line 70 and the other portion 74 of the bypass line 70 may be divided from each other at dividing points 81 and 82 as illustrated in FIG. 9 by a computer-controlled laser beam or other appropriate means. Thus, a consecutive series of the defective unit cells C4 and C5 may be eliminated from the array of the successive unit cells 5 connected in series with each other while the series connection of good cells is maintained.

In the second bypassing, the repair pads 30 next adjacent to each other are connected to each other without using the bypass line 70 (step S30).

For example, when a defective unit cell C1 is between normal unit cells C2 and C3 (cells that are operative within prespecified mass production specifications), and normal unit cell C2 is next adjacent to the defective unit cell C1 in the D1 direction, the repair pad 30 extending from the lower electrode 11 of the defective unit cell C1 is connected to the repair pad 30 extending from the lower electrode 11 of the next adjacent (in D1 direction) normal unit cell C2 by a third bridge 33. This shorts out the defective unit cell C1 as seen in Fig. 10. Thus the defective unit cell C1 may be eliminated from the array of the successive unit cells 5 which otherwise remain connected in series with each other.

In this exemplary embodiment, when the topmost unit cell 5 and/or the bottom most unit cell 5 are defective (see again Fig. 1 and module output lines 93, 95), a third bypassing may further be performed. In the third bypassing, the first module output line 93 and/or the second module output line 95 are respectively divided off from the repair pads 30 of the top unit cell 5 and the bottom unit cell 5 respectively as appropriate for the given repair. The first module output line 93 and/or the second module output line 95 are then directly connected to the top end and/or the bottom end of the bypass line 70 respectively as appropriate for the given repair. The bypass line 70 is then connected to the repair pads 30 of a new next topmost operative unit cell 5 and/or a new next bottom most operative unit cell 5 of the array of successive unit cells 5 as appropriate for the given repair. Thus, the primarily defective top and bottom unit cells 5 may be eliminated from the array of the successive unit cells 5 connected in series with each other.

The performing order for steps of the method for repairing the solar energy module 1 in FIGS. 5 to 9 may be varied from that recited above.

FIG. 10 is an equivalent circuit diagram illustrating the solar energy module 1 in FIG. 9.

Referring to FIG. 10, when the defective unit cells C4 and C5 are consecutive, the defective unit cells C4 and C5 are skipped over in the array of the successive unit cells 5 by the first bypassing using portion 72 of the bypass line 70. When the nonconsecutive single defective unit cell C1 is next adjacent (in the D1 direction) to the normal unit cell C2, the nonconsecutive defective unit cell C1 is directly connected to the normal unit cell C2 by bridging together their repair pads so that the normal unit cells C2 and C3 on both sides of the defective unit cell C1 are thereby electrically connected around the defective unit cell C1 by the second, repair-pads-only bypassing without use the bypass line 70.

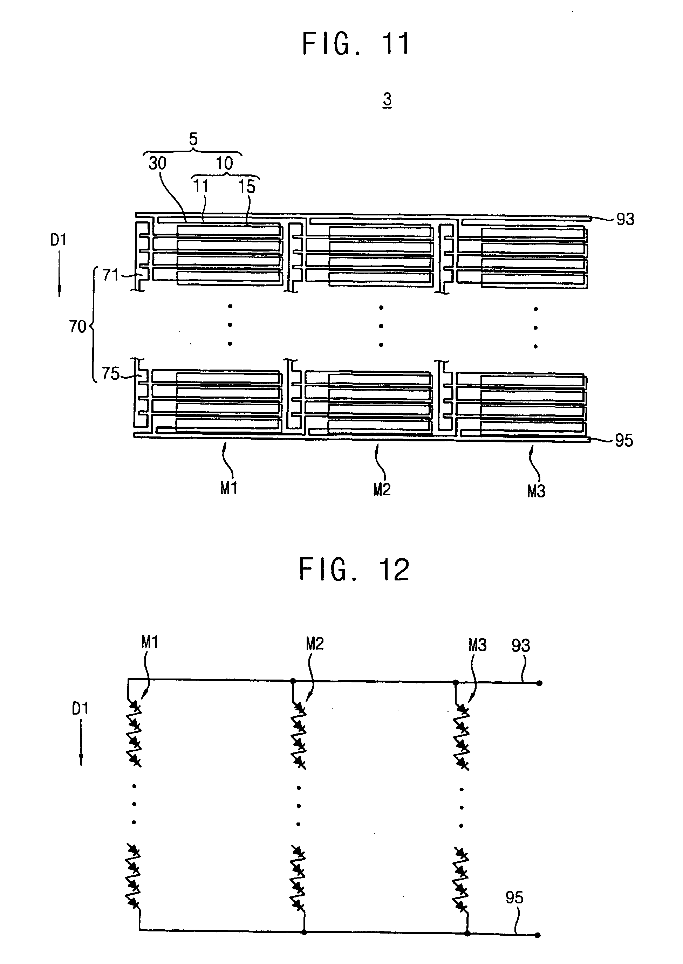

FIG. 11 is a plan view illustrating a solar energy assembly 3 having a plurality of modules in accordance with a first embodiment of Fig. 1. FIG. 12 is an equivalent circuit diagram illustrating the solar energy assembly 3 in FIG. 11.

Referring to FIGS. 11 and 12, in this example embodiment, the solar energy assembly 3 includes a plurality of solar energy modules M1, M2 and M3, where the respective first module output lines 93 and the second module output lines 95 are integrally connected together to define respective first and second assembly output lines 93' and 95' (same reference number used here).

In the embodiment of Fig. 11, the three modules M1, M2 and M3 are integrally disposed side-by-side on a common monolithic substrate (e.g., a glass plate). Alternatively, the solar energy modules M1, M2 and M3 may be individually attached as separate substrates to form a common substrate and/or they are mounted to an underlying common substrate and connections between the respective module output lines 93 and 95 are made so as to provide substantially equivalent couplings in the assembly wherein the three modules M1, M2 and M3 are connected in parallel to one another by means of the first output line 93 and the second output line 95. As seen, in Fig. 11, the first output line 93 is an integral extension of the topmost repair pads, and the second output line 95 is an integral extension of the bottommost repair pads while first and second portions 71, 75 of the adjacent bypass lines 70 may be cut apart from one another.

The solar energy modules M1, M2 and M3 are substantially the same as the solar energy module 1 illustrated in FIGS. 1 to 4, except for the fact that the first module output lines 93' and the second module output lines 95 are joined together respectively. Thus, corresponding reference numbers are used for corresponding elements and further descriptions of the solar energy modules M1, M2 and M3 of this example embodiment are omitted.

In this example embodiment, each of the solar energy modules M1, M2 and M3 is fabricated to include a respective bypass line 70. The bypass line 70 includes a first bypass line portion 71 and a second bypass line portion 75 where the latter may be cut apart from the first bypass line portion 71 if desired.

The first output line 93 integrally connects the repair pads 30 of the unit cells 5 corresponding to the high-voltage output terminals of the solar energy modules M1, M2 and M3 in parallel with each other. The second output line 95 integrally connects the repair pads 30 of the unit cells 5 corresponding to the low-voltage output terminals of the solar energy modules M1, M2 and M3 in parallel with each other. In this example embodiment, the high-voltage output terminal and the low-voltage output terminal correspond to the topmost unit cell 5 and the bottom most unit cell 5 of each of the solar energy modules M1, M2 and M3.

The solar energy modules M1, M2 and M3 of the solar energy assembly 3 may initially include the same number of operative unit cells 5. When module output voltage is drawn out from the same number of the unit cells 5 in each of the solar energy modules M1, M2 and M3, the isolated module output voltage of each solar energy modules M1, M2 and M3 may nonetheless be different from each other due to variations in a manufacturing process. (In one embodiment, isolated module output voltages are estimated by adding the individually measured IV curves of the operative cells and determining expected total voltage for a given expected current flow.) When the module output voltage of each of the solar energy modules M1, M2 and M3 are different from each other, the lifetimes of the solar energy modules M1, M2 and M3 and the solar energy assembly 3 may be reduced due to the flow of undesired shunt currents.

Thus, it is desirable to make the isolated module output voltages as close to each other as practical for expected operating conditions (e.g., expected current outputs). In order to make the module output voltages be substantially the same as each other, the number of operative unit cells 5 between the high-voltage output terminal and the low-voltage output terminal may be trimmed to be different from each other in the respective solar energy modules M1, M2 and M3. Thus, the module output voltages in the solar energy modules M1, M2 and M3 may be individually trimmed so as to be substantially the same as each other. Trimming may be carried out with or without repair of defective cells.

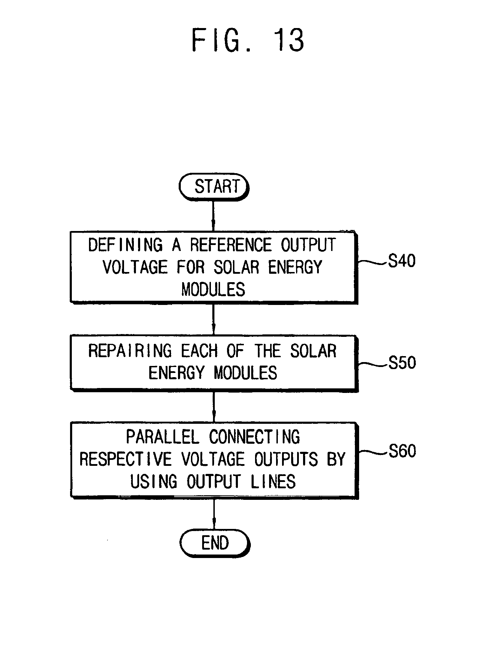

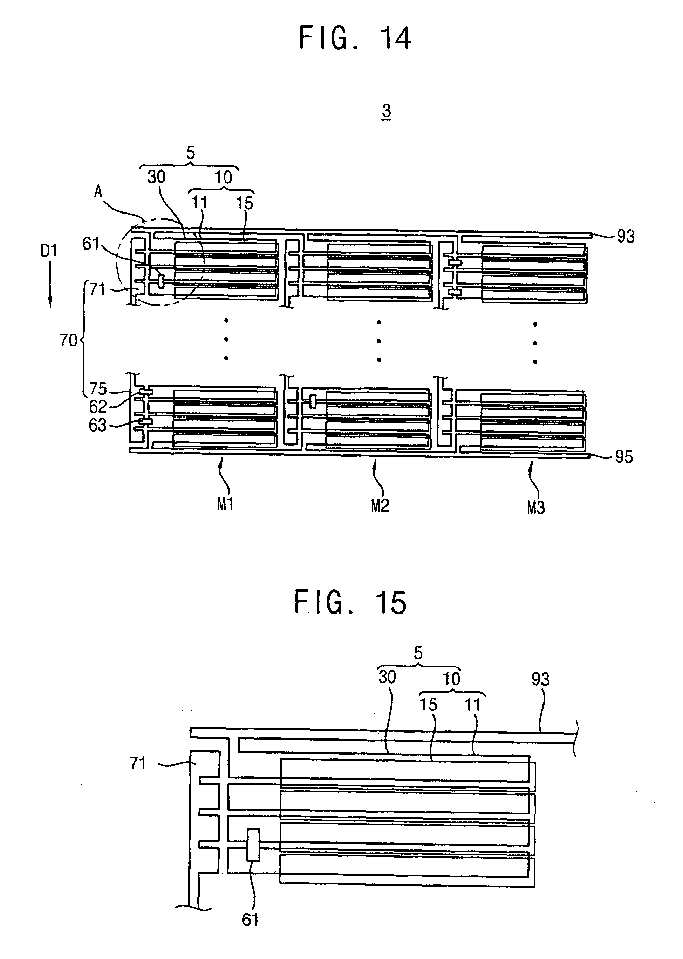

FIG. 13 is a flowchart illustrating a method of trimming for the solar energy assembly 3 in accordance with a first embodiment. FIG. 14 is a plan view illustrating a solar energy assembly 3 including solar energy modules M1, M2 and M3 which have been trimmed to have substantially the same module output voltage as each other. FIG. 15 is an enlarged view illustrating a first area A in FIG. 14.

Referring to FIGS. 13 to 15, a method of trimming for a solar energy assembly 3 may be automated so as to be implemented substantially by computer-driven test and repair equipment and may be used to automatically trim the solar energy modules in the solar energy assembly 3 in FIG. 11 to have substantially the same individual module output voltages as each other.

In the method of testing and trimming for a solar energy assembly 3, a reference output voltage is produced by a reference source (not shown) for common use in performing testing and trimming among the individual solar energy modules M1, M2 and M3 (step S40).

To produce the reference output voltage, unit output voltages of normal unit cells 5 of the solar energy modules M1, M2 and M3 are sampled at different current levels (including for example by driving the unit cells with a reference current source that produces one or more predefined reference current magnitudes) using a probe such as illustrated in FIG. 6 or FIG. 7 and the individual cell voltages of operative (normal) cells are summed by the test computer or otherwise to thereby determine the respective isolated module output voltages of each solar energy modules M1, M2 and M3 under expected operating conditions (e.g., when solar radiation is such that each module produces an expected current output). In one embodiment, the lowest of the determined individual module output voltages is defined as the reference output voltage. In an alternate embodiment, a voltage slightly lower than the lowest of the determined individual module output voltages may be defined as a common lowest denominator or reference output voltage to which all the modules will be trimmed.

After determining the reference output voltage, the solar energy modules M1, M2 and M3 are repaired and/or trimmed so as to make each of the module output voltage of solar energy modules M1, M2 and M3 be substantially the same as the reference output voltage (step S50).

A method of repairing and trimming the solar energy modules M1, M2 and M3 may be substantially the same as the method of repairing the solar energy module 1 illustrated in FIGS. 5 to 10, except that not only are defective unit cells bypassed but also one or more normal unit cells may be bypassed for trimming the modules of the solar energy assembly 3 and thereby substantially equalizing their respective, isolated output voltages.

For example, when one or more module output voltages of the solar energy modules M1, M2 and M3 may be higher than the reference output voltage, at least one unit cell 5 between the top unit cell 5 and the bottom unit cell 5 of the solar energy modules M1, M2 and M3 may be excluded (bypassed) from the array of unit cells 5 thus eliminating its contribution to the total module output voltage.

In FIG. 14, a first solar energy module M1 is repaired and/or trimmed by using the first bypassing and the second bypassing, a second solar energy module M2 is repaired or trimmed by using the second bypassing and a third solar energy module M3 is repaired or trimmed by using the first bypassing. As a result of the repairing and/or trimming, each of the module output voltage of solar energy modules M1, M2 and M3 becomes substantially the same as the reference output voltage.

After trimming by repairing or otherwise, in one embodiment, the originally isolated output terminals of the solar energy modules M1, M2 and M3 are connected to each other in parallel by the assembly output lines (step S60).

For example, the first output line 93 integrally connects the repair pads 30 of the unit cells 5 corresponding to the high-voltage output terminals of the solar energy modules M1, M2 and M3 in parallel with each other. The second output line 95 integrally connects the repair pads 30 of the unit cells 5 corresponding to the low-voltage output terminals of the solar energy modules M1, M2 and M3 in parallel with each other.

FIG. 16 is a plan view illustrating a solar energy module 301 in accordance with a second example embodiment.

The solar energy module 301 is substantially the same as the solar energy module 1 illustrated in FIGS. 1 to 4, except that the module out put lines 393, 395 are originally (prior to cutting and bridging) integrally connected to a bypass line 370. Corresponding reference numbers are used in Fig. 16 for corresponding elements and thus further descriptions of the solar energy module 301 beyond those involving the differences of this example embodiment are omitted.

In this example embodiment 301, the first module output line 393 and the second module output line 395 are respectively connected directly to the top end and the bottom end of the bypass line 370. In FIG. 16, a top unit cell 5 and a bottom unit cell 5 are normal and correspond to a high-voltage terminal and a low-voltage terminal of the solar energy module 301 respectively. The first out put line 393 and the second output line 395 are electrically connected to the repair pads 330 of unit cells correspond to the high-voltage terminal and the low-voltage terminal by the bypass line 370 and by a first bridge 361 that couples the cut line 370 to the top cell and by a second bridge 362 that couples the cut line 370 to the bottom cell. More specifically, isolated top and bottom portions of the bypass line 370 are defined by selective cutting of the bypass line 370 and these isolated top and bottom portions are selectively connected by bridges 361, 362 to the respective repair pads 330 of the high-voltage cell and the low-voltage cell. Alternatively, if the top unit cell 5 and/or the bottom unit cell 5 had been defective, the selective cutting of the bypass line 370 to define its isolated top and bottom portions may have been carried out differently and/or the selective formation of bridges to operative unit cells 5 may have been carried out differently so as to tap to the corresponding high-voltage terminal and low-voltage terminal of the module 301.

In this example embodiment, a method of repairing the solar energy module 301 is substantially the same as the method of repairing the solar energy module illustrated in FIGS. 5 to 10, except that of not including the third bypassing, further including connecting the bypass line 370 to the repair pads 330 correspond to the high-voltage terminal and the low-voltage terminal, and further including dividing portions of the bypass line 370 connected to the repair pads 330 correspond to the high-voltage terminal and the low-voltage terminal from the other of the bypass line 370. Thus, further descriptions of the method of repairing the solar energy module 301 of this example embodiment are omitted.

In FIG. 16, the solar energy module 301 is repaired by the second bypassing so that one of the unit cells 305 connected to each other by the third bridge 363 may be excluded (bypassed) from the array of the unit cells 305.

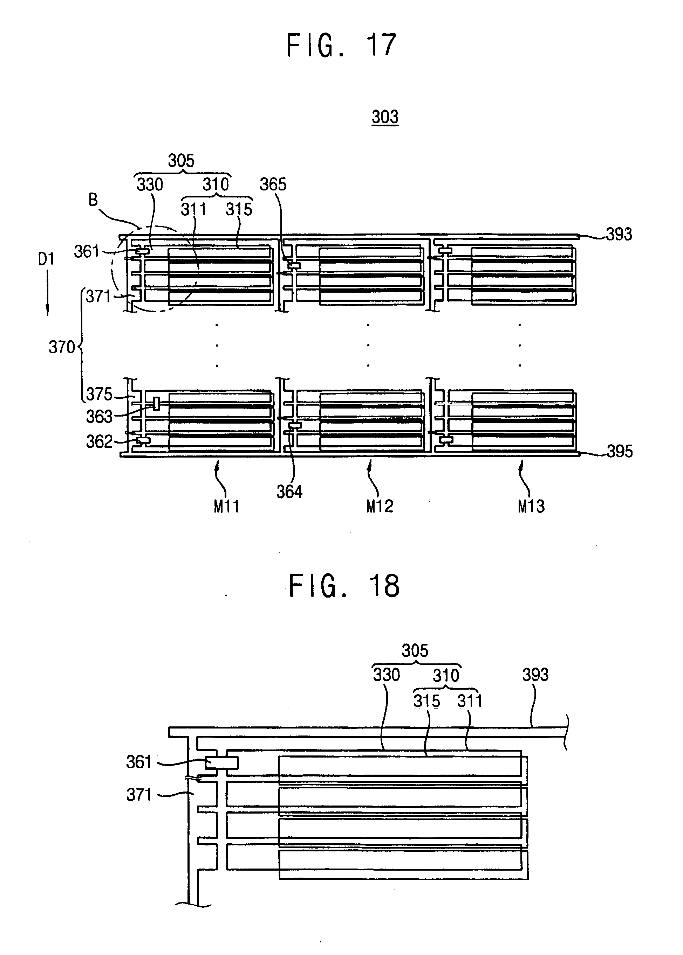

FIG. 17 is a plan view illustrating a solar energy assembly 303 including solar energy modules M1, M2 and M3 which may be trimmed to have substantially the same module output voltages as each other in accordance with a second embodiment. FIG. 18 is an enlarged view illustrating a second area B in FIG. 17.

Referring to FIGS. 17 and 18, in this example embodiment, the solar energy assembly 303 is substantially the same as the solar energy assembly 3 illustrated in FIGS. 11 and 12, except for using the solar energy module 301 illustrated in FIG. 16. Thus, corresponding reference numbers are used for corresponding elements and further descriptions of the solar energy assembly 303 of this example embodiment are omitted.

In this example embodiment, a method of trimming for the modules of the solar energy assembly 303 is substantially the same as method of trimming for the solar energy assembly 3 illustrated in FIGS. 13, 14 and 15, except for a method of connecting output terminals of solar energy modules M1, M2 and M3 in parallel with each other by output lines.

In this example embodiment, the method of connecting output terminals of the solar energy modules M1, M2 and M3 are the same as a method illustrated in FIG. 16. The repair pads 330 of unit cells 305 correspond to the high-voltage terminal and the low-voltage terminal of each of the solar energy modules M1, M2 and M3 are connected to a first bypass line portion 371 and a second bypass line portion 375 by the first bridge 361 and the second bridge 362 respectively. The first assembly output line 393 and the second assembly output line 395 are directly and originally connected to the top end portion of the first bypass line portion 371 and the bottom end portion of the second bypass line portion 375 respectively.

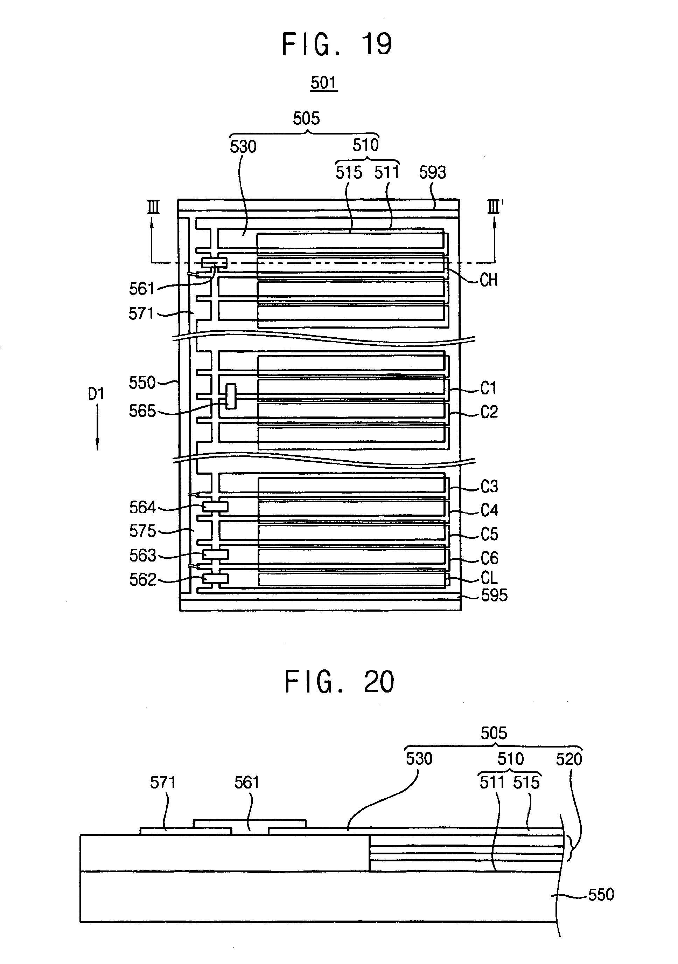

FIG. 19 is a plan view illustrating a solar energy module 501 in accordance with another example embodiment. FIG. 20 is a cross-sectional view illustrating the solar energy module 501 taken along a line III-III' in FIG. 19.

Referring to FIG. 19 and 20, in this example embodiment, the solar energy module 501 is substantially the same as the solar energy module 1 illustrated in FIGS. 16 to 18, except for the location of repair pad 530 and adjacent bypass line 571 (which as seen in Fig. 20 are disposed in line with the top of the unit cell 505 rather than its bottom). Thus, corresponding reference numbers are used for corresponding elements and further descriptions of the solar energy module 501 of this example embodiment are omitted.

In this example embodiment, the special repair pad 530 extends from an upper electrode layer 515 of a unit cell 505 and protrudes out of one side of the unit cell 505 to rest on an adjacent insulating step. Bypass line 570 is formed also on the stepped up insulator (mounted on substrate 550) so as to have substantially the same layer height as the repair pad 530.

In a method of repairing for a solar energy module 501 in this example embodiment, when two defective unit cells C5 and C6 are successively disposed, the consecutive defective unit cells C5 and C6 are excluded from the array of unit cells 505 by a first bypassing. For example, the repair pad 530 which extends from the upper electrode 515 of the defective unit cell C6 next adjacent to the defective unit cell C5 along the first direction D1 is connected to a second bypass line 571 by a first bridge 563. In addition, the repair pad 530 extending from the upper electrode 515 of a normal unit cell C4 is connected with the second bypass line 571 by a second bridge 564. The normal unit cell 505 is next adjacent to the defective unit cell C5 along the opposite direction to the first direction D1.

The method of repairing the solar energy module 501 in this example embodiment is substantially the same as the method of repairing the solar energy module 301 illustrated in FIGS. 16 to 18, except for the elements mentioned above. Thus, corresponding reference numbers are used for corresponding elements and further descriptions of the method of repairing the solar energy module 501 in this example embodiment are omitted.

The solar energy assembly in this example embodiment is functionally, substantially the same as the solar energy assembly illustrated in FIGS. 17 and 18, except for including the solar energy module 501 illustrated in FIGS. 19 and 20. Thus, further descriptions of the solar energy assembly in this example embodiment are omitted.

The method of trimming the solar energy assembly in this example embodiment is substantially the same as the method of trimming the solar energy assembly illustrated in FIGS. 16 to 18, except for using the method of repairing the solar energy assembly of this example embodiment. Thus, further descriptions of the method of trimming the solar energy assembly in this example embodiment are omitted.

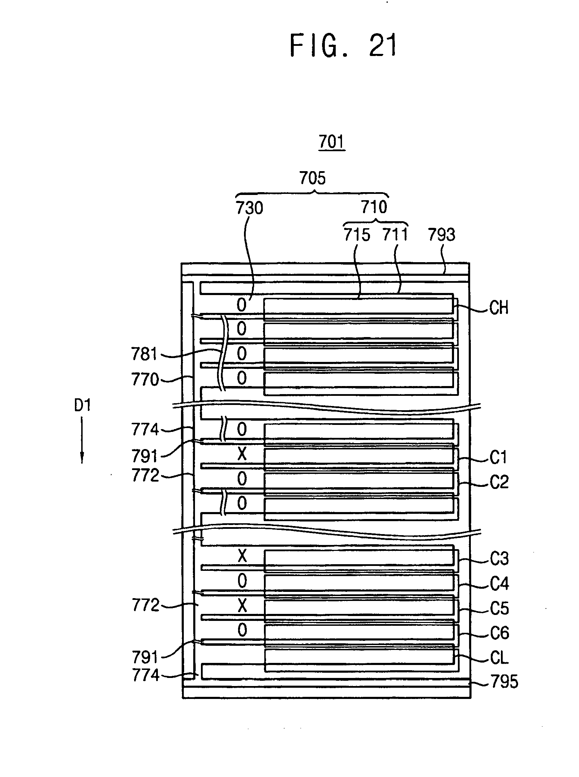

FIG. 21 is a plan view illustrating a solar energy module 701 in accordance with still another example embodiment.

Referring to FIG. 21, the solar energy module 701 in this example embodiment is substantially the same as the solar energy module 301 illustrated in FIGS. 16 to 18, except that repair pads 730 extend from the lower electrode layers 711 of the unit cells 705, respectively, and all of the repair pads 730 are initially all formed to integrally join with the bypass line 770. In other words, all the bridges from the respective repair pads 730 to the bypass line 770 are initially intact rather than open circuits. Further descriptions of non-different details of the solar energy module 701 in this example embodiment are omitted.

In this example embodiment, when all of the unit cells 705 are proven to be normal by test (automated or otherwise), cuts are made; by laser beam or otherwise for all originally intact bridges except for the repair pads 730 of the unit cells 705 corresponding to the high-voltage output terminal and the low-voltage output terminal, the bridge portions of the repair pads 730 of the other unit cells 705 thus separating the other cells from the bypass line 770. As with detection and selection steps described above, various detection and selection steps (e.g., deciding which bridges to cut) described below may be carried out by automated means such as by use of appropriate software provided in a general purpose or special purpose computer.

If defective unit cells such as C1, C3 and C5 are detected among the unit cells 705 then the following procedure may be used. The positions of defective unit cells C1, C3 and C5 are marked as defective ones in a computer readable memory, for example with an X symbol for purposes of illustration and the positions of normal unit cells 705 are marked with an O as illustrated in FIG. 21 (where the marking is either actually on the substrate and/or virtually by use of appropriate computer software). The solar energy module 701, which is repaired by bypassing the defective unit cells C1, C3 and C5, is illustrated in FIG. 21.

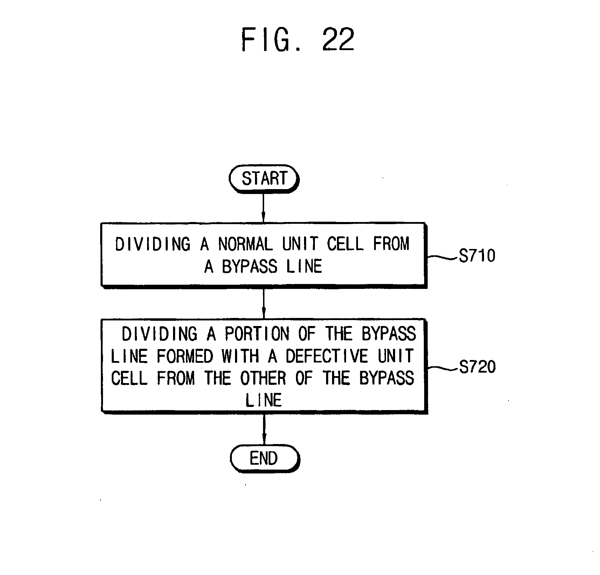

FIG. 22 is a flowchart illustrating method of repairing the solar energy module 701 in FIG. 21.

Referring to FIG. 21 and 22, in the method of repairing the solar energy module 701, an electrode layers 710 of the normal unit cells 705are electrically cut from the bypass line 770 (step S710).

For example, the repair pads 730 which extend from the lower electrode layers 711 of the normal unit cells 705 are cut from the bypass line 770 at cutting points 781 using a laser beam or another appropriate selective and computer controlled cutting method. While the repair pads 730 of normal unit cells C2, C4 and C6 next adjacent to the defective unit cells C1, C3 and C5 along the first direction D1 are not divided from the bypass line 770 but maintained to be initially integral formed state with the bypass line 770.

Portions of the bypass line 770 integrally formed with the defective unit cells and the next adjacent normal unit cells are divided from the other of the bypass line 770 (step S720).

For example, first portions 772 of the bypass line 770 which connects the defective unit cells C1, C3 and C5 with the normal unit cells C2, C4 and C6 adjacent to the defective unit cells C1, C3 and C5 along the first direction D1 are divided from second portions 774 of the bypass line 770. Thus, the lower electrode layers 711 of the defective unit cells C1, C3 and C5 and the lower electrode layers 711 of the normal unit cells C2, C4 and C6 are electrically connected to each other, so that the defective unit cells C1, C3 and C5 may be bypassed and cannot contribute to the module output voltage.

In the method of repairing the solar energy module 701, the normal unit cells CH and CL which respectively correspond to the high-voltage output terminal and the low-voltage output terminal of the solar energy module 701 are not cut from the bypass line 770.

The solar energy assembly in this example embodiment is substantially the same as the solar energy assembly illustrated in FIGS. 16 to 18, except for including the solar energy module 701 in FIG. 21. Thus, further descriptions of the solar energy assembly in this example embodiment are omitted.

The method of trimming the solar energy assembly in this example embodiment is substantially the same as the method of trimming the solar energy assembly illustrated in FIGS. 16 to 18 except using the method of repairing the solar energy module illustrated in FIGS. 21 and 22. Thus, further descriptions of the method of trimming the solar energy assembly in this example embodiment are omitted.

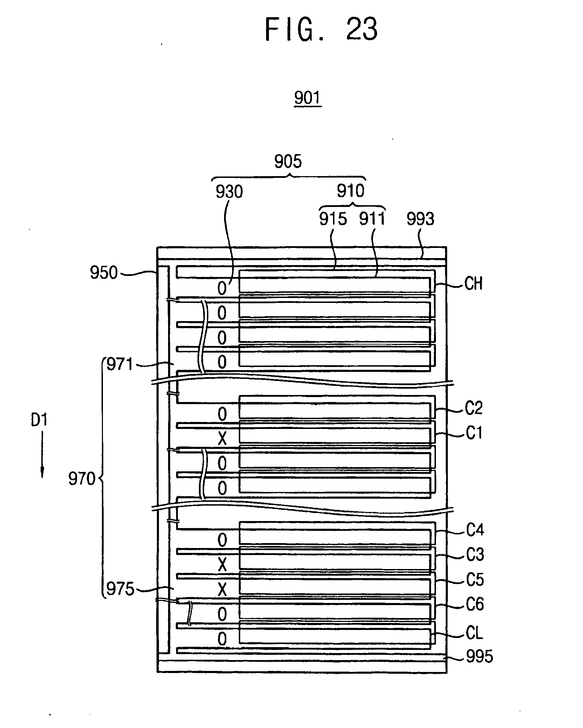

FIG. 23 is a plan view illustrating a solar energy module 901 in accordance with a fifth embodiment.

Referring to FIG. 23, the solar energy module 901 in this example embodiment is substantially the same as the solar energy module 701 illustrated in FIG. 21 except that the repair pads 930 extend from the upper electrode layer 915 of the unit cell 905. Thus, further descriptions of the solar energy module 901 in this example embodiment are omitted.

In a method of repairing solar energy module 901 in this example embodiment, the repair pads 930 which extend from the upper electrode layers 915 of the normal unit cells 905 are cut from the bypass line 970 at cutting points defined along the pads 930. While the repair pads 930 of normal unit cells C2, C4 and C6 next adjacent to the defective unit cells C1, C3 and C5 along the opposite direction to the first direction D1 are not divided from the bypass line 970 but maintained to be initially integral formed state with the bypass line 970. Thus, the upper electrode layers 911 of the defective unit cells C1, C3 and C5 and the upper electrode layers 911 of the normal unit cells C2, C4 and C6 are electrically connected to each other, so that the defective unit cells C1, C3 and C5 may be bypassed and cannot contribute to the module output voltage.

Except for the above mentioned, the method of repairing solar energy module 901 is substantially the same as the method of repairing solar energy module 701 illustrated in FIG. 21 and 22. Thus, further descriptions of the method of repairing the solar energy module 901 in this example embodiment are omitted.

The solar energy assembly in this example embodiment is substantially the same as the solar energy assembly illustrated in FIGS. 16 to 18, except including the solar energy module 901 in FIG. 23. Thus, further descriptions of the solar energy assembly in this example embodiment are omitted.

The method of trimming the solar energy assembly in this example embodiment is substantially the same as the method of trimming the solar energy assembly illustrated in FIG. 23 except using the method of repairing the solar energy module 901 illustrated in FIG. 23. Thus, further descriptions of the method of trimming the solar energy assembly in this example embodiment are omitted.

According to some example embodiments of the present disclosure, one or more defective unit cells 905 may be bypassed so that the mass production yields of the solar energy module and the solar energy assembly may be increased. Also, the isolated module output voltages of the solar energy modules may be made more uniform by trimming so that the reliability of the solar energy module and the solar energy assembly may be increased. Thus, the present disclosure may be used in manufacturing and repairing of solar energy modules such as those that includes unit cells of a thin-film type connected in series with each other and the solar energy assembly including a plurality of such solar energy modules.

The foregoing is illustrative and is not to be construed as limiting of the teachings provided herein. Although a few example embodiments have been described, those skilled in the art will readily appreciate from the above that many modifications are possible in the example embodiments without materially departing from the novel teachings and advantages of the present disclosure. Accordingly, all such modifications are intended to be included within the scope of the present teachings. In the below claims, means-plus-function clauses are intended to cover the structures described herein as performing the recited function and not only structural equivalents but also functionally equivalent structures. Therefore, it is to be understood that the foregoing is illustrative and is not to be construed as limited to the specific example embodiments disclosed, and that modifications to the disclosed example embodiments, as well as other example embodiments, are intended to be included within the scope of the teachings.

## Claims

1. A solar energy module comprising:
a plurality of successive unit cells (5), each unit cell including:
a set of electrode layers (10) comprising a lower electrode layer (11) and an upper electrode layer (15);
a set of one or more semiconductor layers (20) disposed between the lower electrode layer and the upper electrode layer and defining a photo-electric converter that coverts photonic energy into electrical energy; and
a repair pad (30) electrically connected to an electrode layer in the set of electrode layers and protruding outwardly so as to allow connection to a like repair pad of an adjacent unit cell and/or connection to another adjacent structure;
wherein an electrode layer of a first unit cell of the successive unit cells electrically connects to an electrode layer of a next adjacent unit cell, if any, of the successive unit cells so that the successive unit cells are thereby connected in series with each other, wherein the unit cells interconnect one to the next along a first direction, and electrical connections from the upper electrode layer of the first unit cell to the lower electrode layer of the next adjacent unit cell are made along the first direction;
the solar energy module further comprising:
a bypass conductor (70) extending adjacent to the plurality of repair pads to function for each unit cell as said other adjacent structure to which the respective repair pad of the unit cell may be connected;
a first module output line (93) connected to a repair pad of a peripheral first unit cell among the successive unit cells;
a second module output line (95) connected to a repair pad of a peripheral second unit cell among the successive unit cells;
a first bridge (35) connecting the repair pad of a corresponding deemed-as-defective unit cell with the bypass conductor; and
a second bridge (37) connecting the repair pad of a corresponding deemed-as-normal unit cell with the bypass conductor,
wherein repair pads of adjacent other cells are primarily not connected to one another, the first and the second bridges thereby define a corresponding parallel bypass circuit around the defective unit cell or around two or more defective unit cells disposed between the first and the second bridges in said series connection of the successive unit cells.

2. The solar energy module of Claim 1, wherein the unit cells are disposed on a substrate (50) such that the lower electrode layer of each cell is closer to the substrate than the upper electrode layer, and wherein each repair pad integral extends from and beyond the lower electrode layer of its respective unit cell.

3. The solar energy module of claim 1, wherein a first portion of the bypass conductor connecting the first bridge to the second bridge is divided from a second other portion of the bypass conductor.

4. The solar energy module of Claim 1, further comprising a third bridge (33) connecting the repair pad of a deemed-as-defective further unit cell with the repair pad of an adjacent deemed-as-normal unit cell so as to thereby define a corresponding parallel circuit bypassing around the defective further unit cell in said series connection of the successive unit cells.

5. The solar energy module of Claim 1, further comprising
a first module output line (93) connected to a first end portion of the bypass conductor; and
a second module output line (95) connected to a second end portion of the bypass conductor;
wherein the first and second module output lines extend in a direction substantially orthogonal to an extension direction of the bypass conductor.

6. The solar energy module of Claim 5, wherein first and second portions of the bypass conductor which are respectively connected with the first and the second module output lines, and respectfully connect with the repair pads of a highest-voltage outputting unit cell and a lowest-voltage outputting unit cell of the module, and the first and second portions of the bypass conductor are respectively divided apart from other portions of the bypass conductor.

7. The solar energy module of Claim 5, wherein each repair pad extends from the lower electrode layer of its respective unit cell.

8. The solar energy module of Claim 5, wherein each repair pad extends from the upper electrode layer.

9. The solar energy module of Claim 5, further comprising
a fourth bridge connecting the repair pad of a corresponding defective unit cell with the bypass conductor; and
a fifth bridge connecting the repair pad of a corresponding normal unit cell with the bypass conductor,
wherein repair pads of adjacent cells are primarily not connected to one another, the fourth and the fifth bridges thereby define a corresponding parallel circuit bypass around the defective unit cell or one or more defective unit cell between the fourth and the fifth bridges in said series connection of the successive unit cells.

10. The solar energy module of Claim 9, wherein a portion of the bypass conductor connecting the fourth bridge to the fifth bridge is divided apart from other portions of the bypass conductor.

11. The solar energy module of Claim 9, further comprising a sixth bridge connecting the repair pad of a defective unit cell with the repair pad of an adjacent normal unit cell so as to thereby define a corresponding parallel circuit bypassing around the defective unit cell in said series connection of the successive unit cells.

12. The solar energy module of Claim 5, wherein the repair pads of the successive unit cells are initially manufactured to be integrally connected with the bypass conductor, and after said initial manufacturing a separation portion is formed on the respective repair pads of deemed-to-be-normal unit cells so as to thereby electrically divide the normal unit cells from the bypass conductor.

13. The solar energy module of Claim 12, wherein portions of the bypass conductor which are integrally formed with the repair pads of the high-voltage outputting unit cell and the low-voltage outputting unit cell are divided from other portions of the bypass conductor.

14. The solar energy module of Claim 12, wherein the repair pad of a normal unit cell next to one side of a defective set of one or more successive defective unit cells is integrally formed with the bypass conductor, the separation portion is formed on the repair pad of a normal unit cell next to the other side of the defective set so that the one or more successive defective unit cells are electrically divided from series connection of the successive unit cells.

15. The solar energy module of Claim 14, wherein a portion of the bypass conductor connecting the one or more successive defective unit cells with each other is divided from other portions of the bypass conductor.

16. A solar energy assembly comprising:
a plurality of solar energy modules according to any preceding claim;
the solar energy assembly further comprising:
a first bypass line (71) extending adjacent to the repair pad of the unit cell whose output corresponds to a high-voltage output of the array;
a second bypass line (75) extending adjacent to the repair pad of the unit cell whose output corresponds to a low-voltage output of the array;
a first output line (93) connecting the respective repair pads corresponds to the high-voltage output of the solar energy modules in parallel with each other;
a second output line (95) connecting to the respective repair pads corresponds to the low-voltage output of the solar energy modules in parallel with each other;
a first bridge (35) connecting the first bypass line to the repair pad corresponding to the high-voltage output; and
a second bridge (37) connecting the second bypass line to the repair pad corresponding to the low-voltage output.

17. The solar energy assembly of Claim 16, wherein the first and the second output lines are directly connected to the repair pads corresponding to the high-voltage output and the low-voltage output respectively.

18. The solar energy assembly of Claim 16, wherein the first output line is directly connected to the first bypass line which is connected to the repair pad corresponding to the high-voltage output; and
the second output line is directly connected to the second bypass line which is connected to the repair pad corresponding to the low-voltage output.

19. The solar energy assembly of Claim 16, wherein a portion of the first bypass line connected to the repair pad corresponding to the high-voltage output is divided from the other of the first bypass line, and
a portion of the second bypass line connected to the repair pad corresponding to the low-voltage output is divided from the other of the second bypass line.

20. The solar energy assembly of Claim 16, wherein each repair pad extends from the lower electrode layer of its respective unit cell.

21. The solar energy assembly of Claim 16, wherein each repair pads extends from the upper electrode layer.

22. The solar energy assembly of Claim 16, wherein the number of the unit cells disposed between the high-voltage output and the low-voltage output is determined so that respective module output voltages of the solar energy modules, whether trimmed or not, are substantially the same as each other.

23. The solar energy assembly of Claim 22, further comprising a third bridge directly connecting the repair pads of adjacent unit cells with each other.

24. The solar energy assembly of Claim 23, at least one of repair pads connected with each other by the third bridge (33) is a repair pad of a defective unit cell.

25. The solar energy assembly of chain 22, wherein at least one of the solar energy modules further comprises at least one of a fourth bridge and a fifth bridge, the fourth bridge directly connecting a first repair pad to the first bypass line, and the fifth bridge directly connecting a second repair pad to the second bypass line.

26. The solar energy assembly of Claim 25, wherein at least one of the first repair pads connected to the first bypass line by a plurality of the fourth bridges respectively is a repair pad of a defective unit cell, and
at least one of the second repair pads connected to the second bypass line by a plurality of the fifth bridges respectively is a repair pad of a defective unit cell.

27. A method of repairing or trimming a solar energy module, the solar energy module according to claim 1, wherein the upper electrode layer (15) which is disposed on a corresponding one or more of the semiconductor layers of each unit cell where the semiconductor layers define a photo-electric converter and the upper electrode layer of a first of the cells being electrically connected to a lower electrode layer (11) under semiconductor layers (20) of a next adjacent unit cell along a first direction so that the successive unit cells are thereby connected in series with each other, the method comprising at least one of performing a first bypassing and performing a second bypassing;
wherein said performing of the first bypassing includes connecting repair pads (30) extending from electrode layers of a first unit cell and a second unit cell to a bypass line so that one or more unit cells including the first unit cell or the second unit cell are bypassed, and
wherein said performing of the second bypassing including directly connecting repair pads of a third unit cell and a fourth unit cell with each other so that at least one of the third unit cell and the fourth cell is bypassed and connecting the repair pads with each other or to the bypass line includes forming pad-to-pad bridge (33) or pad-to-bypass bridge (35, 37).

28. The method of repairing or trimming a solar energy module of Claim 27, wherein performing the first bypassing and the second bypassing, electrically connecting a repair pad extending from the lower electrode of a defective unit cell to a repair pad extending from the lower electrode of a next adjacent unit cell along the first direction.

29. The method of Claim 27, wherein performing the first bypassing and the second bypassing, electrically connects a repair pad extending from the upper electrode of a defective unit cell to a repair pad extending from the upper electrode of a next adjacent unit cell along the opposite direction to the first direction.

30. The method of Claim 27, wherein performing the first bypassing further includes dividing a portion of bypass line which connects the repair pads of the first and the second unit cells from the other of the bypass line.

31. The method of Claim 27, further comprising:
dividing a module output line from the repair pad of a peripheral first unit cell of the array;
connecting the module output line to an end portion of the bypass line; and
dividing a portion of the bypass line connected to the output line from another portion of the bypass line.

32. A method of repairing a solar energy module according to claim 1 an upper electrode layer (15) which is disposed on one or more semiconductor layers of the unit cell defining a photo-electric converter being electrically connected to a lower electrode layer (11) under semiconductor layers (20) of a next adjacent unit cell along a first direction so that the successive unit cells are connected in series with each other, the method comprising
dividing the repair pad (30) extending from an electrode layer of a normal unit cell and primarily integrally formed with bypass line (70) from the bypass line; and
dividing a portion of the bypass line (70) primarily integrally formed with a defective unit cell from the other of the bypass line.

33. The method of repairing a solar energy module of Claim 32, wherein the repair pad extending from the lower electrode of the normal unit cell next adjacent the defective unit cell along the first direction is not divided from the bypass line but is maintained to be primarily integral formed-state.

34. The method of repairing a solar energy module of Claim 32, wherein the repair pad extending from the upper electrode of the normal unit cell adjacent the defective unit cell along the opposite direction to the first direction is not divided from the bypass line but is maintained to be primarily integral formed-state.

35. The method of repairing a solar energy module of Claim 32, further comprising dividing a portion of the bypass line, the portion of the bypass line integrally formed with the repair pad corresponding to voltage output of the array and connected to output line of the solar energy module.

36. A method of trimming a solar energy assembly, the solar energy assembly according to claim 16, wherein the upper electrode layer (15) which is disposed on a corresponding one or more of the semiconductor layers (20) of each unit cell the method comprising
defining a voltage which is to be substantially output by all the solar energy modules of the assembly as a reference output voltage;
where necessary bypassing one or more cells in each of the solar energy modules so as to thereby cause each to have the reference output voltage; and
parallel connecting respective voltage outputs of the solar energy modules with each other by using output lines of the solar energy modules, wherein parallel connecting respective voltage outputs comprises:
connecting a repair pad of a to unit cell to a first bypass line connected to a first output line of each solar energy modules, the top unit cell among the selected number of unit cells for the solar energy module to have an output voltage substantially the same as the reference output voltage; and
connecting a repair pad of a bottom unit cell among the selected number of unit cells to a second bypass line connected to a second output line of each solar energy modules, and connecting the repair pads with each other or to the bypass line includes forming pad-to-pad bridge (33) or pad-to-bypass bridge (35, 37).

37. The method of trimming a solar energy assembly of Claim 36, wherein defining the reference output voltage comprises:
detecting unit output voltages of the unit cells of the solar energy module using a probe; and
determining the module output voltage of each solar energy module as the total of the detected unit output voltages of its unit cells.

38. The method of trimming a solar energy assembly of Claim 37, wherein parallel connecting respective voltage outputs comprises:
connecting a first output line of each solar energy modules with each other, each of the first output lines (93) being directly connected to a repair pad of a top unit cell whose output corresponds to a high-voltage output of the array; and
connecting a second output line (95) of each solar energy modules with each other, each of the second output lines being directly connected to a repair pad of a bottom unit cell whose output corresponds to a low-voltage output of the array.

39. The method of trimming a solar energy assembly of Claim 36, wherein parallel connecting respective voltage outputs further comprises:
dividing a portion of the first bypass line connecting the repair pad of the top unit cell to the first output line from the other of the first bypass line; and
dividing a portion of the second bypass line connecting the repair pad of the bottom unit cell to the second output line from the other of the second bypass line.

40. The method of trimming a solar energy assembly of Claim 37, wherein repairing each of the solar energy modules comprises bypassing at least one unit cell of at least one solar energy module.

41. The method of trimming a solar energy assembly of Claim 37, wherein bypassing at least one unit cell comprises at least one of performing a first bypassing and performing a second bypassing,
performing the first bypassing including connecting repair pads extending from electrode layers of a first unit cell and a second unit cell to a bypass line so that one or more unit cells including the first unit cell or the second unit.cell are bypassed, and
Performing the second bypassing including directly connecting repair pads of a third until cell and a fourth unit cell with each other so that at least one of the third unit cell and the fourth unit cell is bypassed.

## Patentansprüche

1. Solarenergiemodul, umfassend:
eine Mehrzahl aufeinanderfolgender Einheitszellen (5), wobei jede Einheitszelle beinhaltet:
eine Gruppe von Elektrodenschichten (10), umfassend eine untere Elektrodenschicht (11) und eine obere Elektrodenschicht (15);
eine Gruppe einer oder mehrerer Halbleiterschicht(en) (20), die zwischen der unteren Elektrodenschicht und der oberen Elektrodenschicht angeordnet ist und einen photoelektrischen Wandler definiert, der photonische Energie in elektrische Energie umwandelt; und
ein Reparaturpad (30), das mit einer Elektrodenschicht aus der Gruppe von Elektrodenschichten elektrisch verbunden ist und nach außen hervorragt, um eine Verbindung mit einem ähnlichen Reparaturpad einer benachbarten Einheitszelle und/oder eine Verbindung mit einer anderen benachbarten Struktur zu ermöglichen;
wobei eine Elektrodenschicht einer ersten Einheitszelle der aufeinanderfolgenden Einheitszellen mit einer Elektrodenschicht einer nächsten benachbarten Einheitszelle, sofern vorhanden, der aufeinanderfolgenden Einheitszellen elektrisch verbunden ist, sodass die aufeinanderfolgenden Einheitszellen dadurch miteinander in Reihe geschaltet sind, wobei die Einheitszellen entlang einer ersten Richtung mit der jeweils nächsten Einheitszelle verbunden sind und elektrische Verbindungen von der oberen Elektrodenschicht der ersten Einheitszelle zur unteren Elektrodenschicht der nächsten benachbarten Einheitszelle entlang der ersten Richtung ausgebildet sind;
wobei das Solarenergiemodul ferner umfasst;
einen Bypassleiter (70), der sich benachbart zur Mehrzahl von Reparaturpads erstreckt, um für jede Einheitszelle als die andere benachbarte Struktur zu fungieren, mit der das jeweilige Reparaturpad der Einheitszelle verbindbar ist;
eine erste Modulausgangsleitung (93), die mit einem Reparaturpad einer peripheren ersten Einheitszelle aus den aufeinanderfolgenden Einheitszellen verbunden ist;
eine zweite Modulausgangsleitung (95), die mit einem Reparaturpad einer peripheren zweiten Einheitszelle aus den aufeinanderfolgenden Einheitszellen verbunden ist;
eine erste Brücke (35), die das Reparaturpad einer entsprechenden als defekt geltenden Einheitszelle mit dem Bypassleiter verbindet; und
eine zweite Brücke (37), die das Reparaturpad einer entsprechenden als regulär geltenden Einheitszelle mit dem Bypassleiter verbindet,
wobei Reparaturpads benachbarter anderer Zellen primär nicht miteinander verbunden sind, wodurch die erste und die zweite Brücke eine entsprechende parallele Bypass-Schaltung um die defekte Einheitszelle bzw. um zwei oder mehr defekte Einheitszellen, die in der Reihenschaltung der aufeinanderfolgenden Einheitszellen zwischen der ersten und der zweiten Brücke angeordnet sind, definieren.

2. Solarenergiemodul nach Anspruch 1, wobei die Einheitszellen so auf einem Substrat (50) angeordnet sind, dass die untere Elektrodenschicht jeder Zelle näher am Substrat ist als die obere Elektrodenschicht, und wobei sich jedes Reparaturpad einstückig von der unteren Elektrodenschicht seiner jeweiligen Einheitszelle und darüber hinaus erstreckt.

3. Solarenergiemodul nach Anspruch 1, wobei ein erster Abschnitt des Bypassleiters, der die erste Brücke mit der zweiten Brücke verbindet, von einem zweiten anderen Abschnitt des Bypassleiters getrennt ist.

4. Solarenergiemodul nach Anspruch 1, ferner umfassend eine dritte Brücke (33), die das Reparaturpad einer weiteren als defekt geltenden Einheitszelle mit dem Reparaturpad einer benachbarten als regulär geltenden Einheitszelle verbindet, um dadurch eine entsprechende Parallelschaltung zur Umgehung der weiteren defekten Einheitszelle in der Reihenschaltung der aufeinanderfolgenden Einheitszellen zu definieren.

5. Solarenergiemodul nach Anspruch 1, ferner umfassend:
eine erste Modulausgangsleitung (93), die mit einem ersten Endabschnitt des Bypassleiters verbunden ist; und
eine zweite Modulausgangsleitung (95), die mit einem zweiten Endabschnitt des Bypassleiters verbunden ist;
wobei sich die erste und die zweite Modulausgangsleitung in einer im Wesentlichen rechtwinklig zu einer Erstreckungsrichtung des Bypassleiters verlaufenden Richtung erstrecken.

6. Solarenergiemodul nach Anspruch 5, wobei der erste und der zweite Abschnitt des Bypassleiters jeweils mit der ersten bzw. zweiten Modulausgangsleitung verbunden sind und jeweils mit den Reparaturpads einer höchste Spannung abgebenden Einheitszelle und einer niedrigste Spannung abgebenden Einheitszelle des Moduls verbunden sind und der erste und der zweite Abschnitt des Bypassleiters jeweils von anderen Abschnitten des Bypassleiters getrennt sind.

7. Solarenergiemodul nach Anspruch 5, wobei sich jedes Reparaturpad von der unteren Elektrodenschicht seiner jeweiligen Einheitszelle erstreckt.

8. Solarenergiemodul nach Anspruch 5, wobei sich jedes Reparaturpad von der oberen Elektrodenschicht erstreckt.

9. Solarenergiemodul nach Anspruch 5, ferner umfassend:
eine vierte Brücke, die das Reparaturpad einer entsprechenden defekten Einheitszelle mit dem Bypassleiter verbindet; und
eine fünfte Brücke, die das Reparaturpad einer entsprechenden regulären Einheitszelle mit dem Bypassleiter verbindet,
wobei Reparaturpads benachbarter Zellen primär nicht miteinander verbunden sind, wodurch die vierte und die fünfte Brücke eine entsprechende parallele Bypass-Schaltung um die defekte Einheitszelle bzw. um eine oder mehrere defekte Einheitszellen zwischen der vierten und der fünften Brücke in der Reihenschaltung der aufeinanderfolgenden Einheitszellen definieren.

10. Solarenergiemodul nach Anspruch 9, wobei ein Abschnitt des Bypassleiters, der die vierte Brücke mit der fünften Brücke verbindet, von anderen Abschnitten des Bypassleiters getrennt ist.

11. Solarenergiemodul nach Anspruch 9, ferner umfassend eine sechste Brücke, die das Reparaturpad einer defekten Einheitszelle mit dem Reparaturpad einer benachbarten regulären Einheitszelle verbindet, um dadurch eine entsprechende Parallelschaltung zur Umgehung der defekten Einheitszelle in der Reihenschaltung der aufeinanderfolgenden Einheitszellen zu definieren.

12. Solarenergiemodul nach Anspruch 5, wobei die Reparaturpads der aufeinanderfolgenden Einheitszellen ursprünglich gefertigt sind, um einstückig mit dem Bypassleiter verbunden zu werden, und nach der ursprünglichen Fertigung auf den jeweiligen Reparaturpads von als regulär geltenden Einheitszellen ein Trennungsabschnitt ausgebildet wird, um so die regulären Einheitszellen vom Bypassleiter elektrisch zu trennen.

13. Solarenergiemodul nach Aspruch 12, wobei Abschnitte des Bypassleiters, die mit den Reparaturpads der Hochspannung abgebenden Einheitszelle und der Niederspannung abgebenden Einheitszelle einstückig ausgebildet sind, von anderen Abschnitten des Bypassleiters getrennt sind.

14. Solarenergiemodul nach Anspruch 12, wobei das Reparaturpad einer regulären Einheitszelle neben einer Seite einer defekten Gruppe einer oder mehrerer aufeinanderfolgender defekten/r Einheitszelle(n) einstückig mit dem Bypassleiter ausgebildet ist, der Trennungsabschnitt auf dem Reparaturpad einer regulären Einheitszelle neben der anderen Seite der defekten Gruppe ausgebildet ist, sodass die eine bzw. mehreren aufeinanderfolgenden defekte(n) Einheitszelle(n) von der Reihenschaltung der aufeinanderfolgenden Einheitszellen elektrisch getrennt ist/sind.

15. Solarenergiemodul nach Anspruch 14, wobei ein Abschnitt des Bypassleiters, der die eine oder mehreren aufeinanderfolgenden defekte(n) Einheitszelle(n) miteinander verbindet, von anderen Abschnitten des Bypassleiters getrennt ist.

16. Solarenergieanordnung, umfassend:
eine Mehrzahl von Solarenergiemodulen nach einem vorangehenden Anspruch;
wobei die Solarenergieanordnung ferner umfasst:
eine erste Bypassleitung (71), die sich benachbart zum Reparaturpad der Einheitszelle erstreckt, deren Ausgang einem Hochspannungsausgang des Arrays entspricht;
eine zweite Bypassleitung (75), die sich benachbart zum Reparaturpad der Einheitszelle erstreckt, deren Ausgang einem Niederspannungsausgang des Arrays entspricht;
eine erste Ausgangsleitung (93), welche die jeweiligen Reparaturpads miteinander verbindet und die dem Hochspannungsausgang der Solarenergiemodule entspricht, die miteinander parallelgeschaltet sind;
eine zweite Ausgangsleitung (95), welche sich mit den jeweiligen Reparaturpads verbindet und die dem Niederspannungsausgang der Solarenergiemodule entspricht, die miteinander parallelgeschaltet sind;
eine erste Brücke (35), welche die erste Bypassleitung mit dem Reparaturpad, das dem Hochspannungsausgang entspricht, verbindet; und
eine zweite Brücke (37), welche die zweite Bypassleitung mit dem Reparatmpad, das dem Niederspannungsausgang entspricht, verbindet.

17. Solarenergieanordnung nach Anspruch 16, wobei die erste und die zweite Ausgangsleitung direkt mit den Reparaturpads, die jeweils dem Hochspannungsausgang bzw. dem Niederspannungsausgang entsprechen, verbunden sind.

18. Solarenergieanordnung nach Anspruch 16, wobei die erste Ausgangsleitung direkt mit der ersten Bypassleitung verbunden ist, welche mit dem Reparaturpad, das dem Hochspannungsausgang entspricht, verbunden ist; und
die zweite Ausgangsleitung direkt mit der zweiten Bypassleitung verbunden ist, welche mit dem Reparaturpad, das dem Niederspannungsausgang entspricht, verbunden ist.

19. Solarenergieanordnung nach Anspruch 16, wobei ein Abschnitt der ersten Bypassleitung, die mit dem Reparaturpad, das dem Hochspannungsausgang entspricht, verbunden ist, vom anderen der ersten Bypassleitung getrennt ist, und
ein Abschnitt der zweiten Bypassleitung, die mit dem Reparaturpad, das dem Niederspannungsausgang entspricht, verbunden ist, vom anderen der zweiten Bypassleitung getrennt ist.

20. Solarenergieanordnung nach Anspruch 16, wobei sich jedes Reparaturpad von der unteren Elektrodenschicht seiner jeweiligen Einheitszelle erstreckt.

21. Solarenergieanordnung nach Anspruch 16, wobei sich jedes Reparaturpad von der oberen Elektrodenschicht erstreckt.

22. Solarenergieanordnung nach Anspruch 16, wobei die Anzahl der zwischen dem Hochspannungsausgang und dem Niederspannungsausgang angeordneten Einheitszellen so festgelegt ist, dass jeweilige Modulausgangsspannungen der Solarenergiemodule, unabhängig davon, ob justiert oder nicht, im Wesentlichen gleich sind.

23. Solarenergieanordnung nach Anspruch 22, ferner umfassend eine dritte Brücke, welche die Reparaturpads benachbarter Einheitszellen direkt miteinander verbindet.

24. Solarenergieanordnung nach Anspruch 23, wobei zumindest eines der durch die dritte Brücke (33) miteinander verbundenen Reparaturpads ein Reparaturpad einer defekten Einheitszelle ist.

25. Solarenergieanordnung nach Anspruch 22, wobei zumindest eines der Solarenergiemodule ferner zumindest eines von einer vierten Brücke und einer fünften Brücke umfasst, wobei die vierte Brücke ein erstes Reparaturpad direkt mit der ersten Bypassleitung verbindet und die fünfte Brücke ein zweites Reparaturpad direkt mit der zweiten Bypassleitung verbindet.

26. Solarenergieanordnung nach Anspruch 25, wobei zumindest eines der ersten Reparaturpads, die jeweils durch eine Mehrzahl der vierten Brücken mit der ersten Bypassleitung verbunden sind, ein Reparaturpad einer defekten Einheitszelle ist, und
zumindest eines der zweiten Reparaturpads, die jeweils durch eine Mehrzahl der fünften Brücken mit der zweiten Bypassleitung verbunden sind, ein Reparaturpad einer defekten Einheitszelle ist.

27. Verfahren zum Reparieren oder Justieren eines Solarenergiemoduls, des Solarmoduls nach Anspruch 1, wobei die obere Elektrodenschicht (15), die auf einer oder mehreren entsprechenden Halbleiterschicht(en) jeder Einheitszelle angeordnet ist, wobei die Halbleiterschichten einen photoelektrischen Wandler definieren und die obere Elektrodenschicht einer ersten der Zellen entlang einer ersten Richtung mit einer unteren Elektrodenschicht (11) unter Halbleiterschichten (20) einer nächsten benachbarten Einheitszelle elektrisch verbunden ist, sodass die aufeinanderfolgenden Einheitszellen dadurch miteinander in Reihe geschaltet sind, wobei das Verfahren mindestens eines von den Folgenden umfasst: das Ausführen einer ersten Umgehung und das Ausführen einer zweiten Umgehung;
wobei das Ausführen der ersten Umgehung das Verbinden von Reparaturpads (30), die sich von Elektrodenschichten einer ersten Einheitszelle und einer zweiten Einheitszelle erstrecken, mit einer Bypassleitung beinhaltet, sodass eine oder mehrere Einheitszelle(n) einschließlich der ersten Einheitszelle oder der zweiten Einheitszelle umgangen wird/werden, und
wobei das Ausfüllen der zweiten Umgehung das direkte Verbinden von Reparaturpads einer dritten Einheitszelle und einer vierten Einheitszelle miteinander beinhaltet, sodass zumindest eines von der dritten Einheitszelle und der vierten Zelle umgangen wird, und das Verbinden der Reparaturpads miteinander oder mit der Bypassleitung das Ausbilden einer Pad-Pad-Brücke (33) oder einer Pad-Bypass-Brücke (35, 37) beinhaltet.

28. Verfahren zum Reparieren oder Justieren eines Solarmoduls nach Anspruch 27, wobei das Ausführen der ersten Umgehung und der zweiten Umgehung das elektrische Verbinden eines Reparaturpads, das sich von der unteren Elektrode einer defekten Einheitszelle erstreckt, mit einem Reparaturpad, das sich von der unteren Elektrode einer nächsten benachbarten Einheitszelle entlang der ersten Richtung erstreckt, umfasst.

29. Verfahren nach Anspruch 27, wobei das Ausführen der ersten Umgehung und der zweiten Umgehung ein Reparaturpad, das sich von der oberen Elektrode einer defekten Einheitszelle erstreckt, mit einem Reparaturpad, das sich von der oberen Elektrode einer nächsten benachbarten Einheitszelle entlang der zur ersten Richtung entgegengesetzten Richtung erstreckt, elektrisch verbindet.

30. Verfahren nach Anspruch 27, wobei das Ausführen der ersten Umgehung ferner das Trennen eines Abschnitts einer Bypassleitung, der die Reparaturpads der ersten und der zweiten Einheitszelle verbindet, vom anderen der Bypassleitung beinhaltet.

31. Verfahren nach Anspruch 27, ferner umfassend:
Trennen einer Modulausgangsleitung vom Reparaturpad einer peripheren ersten Einheitszelle des Arrays;
Verbinden der Modulausgangsleitung mit einem Endabschnitt der Bypassleitung; und
Trennen eines Abschnitts der Bypassleitung, der mit der Ausgangsleitung verbunden ist, von einem anderen Abschnitt der Bypassleitung.

32. Verfahren zum Reparieren eines Solarenergiemoduls nach Anspruch 1, wobei eine obere Elektrodenschicht (15), die auf einer oder mehreren einen photoelektrischen Wandler definierenden Halbleiterschicht(en) der Einheitszelle angeordnet ist, mit einer unteren Elektrodenschicht (11) unter Halbleiterschichten (20) einer nächsten benachbarten Einheitszelle entlang einer ersten Richtung elektrisch verbunden ist, sodass die aufeinanderfolgenden Einheitszellen miteinander in Reihe geschaltet sind, wobei das Verfahren umfasst:
Trennen des Reparaturpads (30), das sich von einer Elektrodenschicht einer regulären Einheitszelle erstreckt und primär einstückig mit der Bypassleitung (70) ausgebildet ist, von der Bypassleitung; und
Trennen eines Abschnitts der Bypassleitung (70), der primär einstückig mit einer defekten Einheitszelle ausgebildet ist, vom anderen der Bypassleitung.

33. Verfahren zum Reparieren eines Solarenergiemoduls nach Anspruch 32, wobei das Reparaturpad, das sich entlang der ersten Richtung von der unteren Elektrode der nächsten neben der defekten Einheitszelle liegenden regulären Einheitszelle erstreckt, nicht von der Bypassleitung getrennt wird, sondern in einem primär einstückig ausgebildeten Zustand gehalten wird.

34. Verfahren zum Reparieren eines Solarenergiemoduls nach Anspruch 32, wobei das Reparaturpad, das sich entlang der zur ersten Richtung entgegengesetzten Richtung von der oberen Elektrode der nächsten neben der defekten Einheitszelle liegenden regulären Einheitszelle erstreckt, nicht von der Bypassleitung getrennt wird, sondern in einem primär einstückig ausgebildeten Zustand gehalten wird.

35. Verfahren zum Reparieren eines Solarenergiemoduls nach Anspruch 32, ferner umfassend das Trennen eines Abschnitts der Bypassleitung, wobei der Abschnitt der Bypassleitung, der einstückig mit dem Reparaturpad ausgebildet ist, einem Spannungsausgang des Arrays entspricht und mit der Ausgangsleitung des Solarenegiemoduls verbunden ist.

36. Verfahren zum Justieren einer Solarenergieanordnung, der Solarenergieanordnung nach Anspruch 16, wobei die obere Elektrodenschicht (15) auf einer oder mehreren entsprechenden Halbleiterschicht(en) (20) jeder Einheitszelle angeordnet ist, wobei das Verfahren umfasst:
Definieren einer Spannung, die im Wesentlichen von allen Solarenergiemodulen der Anordnung ausgegeben werden soll, als eine Referenzausgangsspannung;
sofern erforderlich, Umgehen einer oder mehrerer Zelle(n) in jedem der Solarenergiemodule, um auf diese Weise dafür zu sorgen, dass jedes die Referenzausgangsspannung aufweist; und
Parallelschalten jeweiliger Spannungsausgänge der Solarenergiemodule miteinander unter Verwendung von Ausgangsleitungen der Solarenergiemodule, wobei das Parallelschalten jeweiliger Spannungsausgänge umfasst:
Verbinden eines Reparaturpads einer oberen Einheitszelle mit einer ersten Bypassleitung, die mit einer ersten Ausgangsleitung jedes der Solarenergiemodule verbunden ist, damit die obere Einheitszelle aus der ausgewählten Anzahl an Einheitszellen für das Solarenenergiemodul eine Ausgansspannung aufweist, die im Wesentlichen dieselbe wie die Referenzausgangsspannung ist; und
Verbinden eines Reparaturpads einer unteren Einheitszelle aus der ausgewählten Anzahl an Einheitszellen mit einer zweiten Bypassleitung, die mit einer zweiten Ausgangsleitung jedes der Solarenergiemodule verbunden ist, und wobei das Verbinden der Reparaturpads miteinander oder mit der Bypassleitung das Ausbilden einer Pad-Pad-Brücke (33) oder Pad-Bypass-Brücke (35, 37) beinhaltet.

37. Verfahren zum Justieren einer Solarenergieanordnung nach Anspruch 36, wobei das Definieren der Referenzausgangsspannung umfasst:
Erfassen von Einheitsausgangsspannungen der Einheitszellen des Solarenergiemoduls unter Verwendung einer Sonde; und
Bestimmen der Modulausgangsspannung jedes Solarenergiemoduls als Summe der erfassten Einheitsausgangsspannungen seiner Einheitszellen.

38. Verfahren zum Justieren einer Solarenergieanordnung nach Anspruch 37, wobei das Parallelschalten jeweiliger Spannungsausgänge umfasst:
Verbinden einer ersten Ausgangsleitung jedes der Solarenergiemodule miteinander, wobei jede der ersten Ausgangsleitungen (93) direkt mit einem Reparaturpad einer oberen Einheitszelle, deren Ausgang einem Hochspannungsausgang des Arrays entspricht, verbunden ist; und
Verbinden einer zweiten Ausgangsleitung (95) jedes der Solarenergiemodule miteinander, wobei jede der zweiten Ausgangsleitungen direkt mit einem Reparaturpad einer unteren Einheitszelle, deren Ausgang einem Niederspannungsausgang des Arrays entspricht, verbunden ist.

39. Verfahren zum Justieren einer Solarenergienordnung nach Anspruch 36, wobei das Parallelschalten jeweiliger Spannungsausgänge ferner umfasst:
Trennen eines Abschnitts der ersten Bypassleitung, die das Reparaturpad der oberen Einheitszelle mit der ersten Ausgangsleitung verbindet, vom anderen der ersten Bypassleitung; und
Trennen eines Abschnitts der zweiten Bypassleitung, die das Reparaturpad der unteren Einheitszelle mit der zweiten Ausgangsleitung verbindet, von dem anderen der zweiten Bypassleitung.

40. Verfahren zum Justieren einer Solarenergieanordnung nach Anspruch 37, wobei das Reparieren jedes der Solarenergiemodule das Umgehen zumindest einer Einheitszelle zumindest eines Solarenergiemoduls umfasst.

41. Verfahren zum Justieren einer Solarenergieanordnung nach Anspruch 37, wobei das Umgehen von zumindest einer Einheitszelle zumindest eines von dem Ausführen einer ersten Umgehung und dem Ausführen einer zweiten Umgehung umfasst,
wobei das Ausführen der ersten Umgehung das Verbinden von Reparaturpads, die sich von Elektrodenschichten einer ersten Einheitszelle und einer zweiten Einheitszelle erstrecken, mit einer Bypassleitung beinhaltet, sodass eine oder mehrere Einheitszelle(n) einschließlich der ersten Einheitszelle oder der zweiten Einheitszelle umgangen werden, und
das Ausführen der zweiten Umgehung das direkte Verbinden von Reparaturpads einer dritten Einheitszelle und einer vierten Einheitszelle miteinander beinhaltet, sodass zumindest eine von der dritten Einheitszelle und der vierten Einheitszelle umgangen wird.

## Revendications

1. Module d'énergie solaire comprenant :
une pluralité de cellules unitaires successives (5), chaque cellule unitaire comprenant :
un ensemble de couches d'électrode (10) comprenant une couche d'électrode inférieure (11) et une couche d'électrode supérieure (15) ;
un ensemble d'une ou plusieurs couches semi-conductrices (20) qui est placé entre la couche d'électrode inférieure et la couche d'électrode supérieure et qui définit un convertisseur photoélectrique qui convertit une énergie photonique en une énergie électrique ; et
une pastille de réparation (30) qui est connectée électriquement à une couche d'électrode de l'ensemble de couches d'électrode et qui se projette en saillie vers l'extérieur de sorte à permettre une connexion à une pastille de réparation similaire d'une cellule unitaire adjacente et/ou une connexion à une autre structure adjacente ;
dans lequel une couche d'électrode d'une première cellule unitaire des cellules unitaires successives se connecte électriquement à une couche d'électrode d'une cellule unitaire adjacente suivante, le cas échéant, des cellules unitaires successives, de telle sorte que les cellules unitaires successives soient ainsi connectées en série les unes avec les autres, dans lequel les cellules unitaires se connectent les unes à la suite des autres dans une première direction, et des connexions électriques, de la couche d'électrode supérieure de la première cellule unitaire à la couche d'électrode inférieure de la cellule unitaire adjacente suivante, se font dans la première direction ;
le module d'énergie solaire comprenant en outre :
un conducteur de contournement (70) qui se prolonge adjacent à la pluralité de pastilles de réparation de sorte à fonctionner, pour chaque cellule unitaire, en tant que ladite autre structure adjacente à laquelle la pastille de réparation respective de la cellule unitaire peut être connectée ;
une première ligne de sortie de module (93) qui est connectée à une pastille de réparation d'une première cellule unitaire périphérique parmi les cellules unitaires successives ;
une seconde ligne de sortie de module (95) qui est connectée à une pastille de réparation d'une deuxième cellule unitaire périphérique parmi les cellules unitaires successives ;
un premier pont (35) qui connecte la pastille de réparation d'une cellule unitaire correspondante, qui est considérée comme étant défectueuse, au conducteur de contournement; et
un deuxième pont (37) qui connecte la pastille de réparation d'une cellule unitaire correspondante, qui est considérée comme étant normale, au conducteur de contournement,
dans lequel des pastilles de réparation d'autres cellules adjacentes ne sont pas initialement connectées les unes aux autres, le premier et le deuxième pont définissant par là même un circuit de contournement parallèle correspondant autour de la cellule unitaire défectueuse ou autour de deux cellules unitaires défectueuses, ou plus, qui sont placées entre le premier et le deuxième pont dans ladite connexion en série des cellules unitaires successives.

2. Module d'énergie solaire selon la revendication 1, dans lequel les cellules unitaires sont placées sur un substrat (50) de telle sorte que la couche d'électrode inférieure de chaque cellule soit plus proche du substrat que la couche d'électrode supérieure, et dans lequel chaque pastille de réparation se prolonge intégralement depuis la couche d'électrode inférieure de sa cellule unitaire respective, et au-delà.

3. Module d'énergie solaire selon la revendication 1, dans lequel une première partie du conducteur de contournement qui connecte le premier pont au deuxième pont est séparée d'une seconde autre partie du conducteur de contournement.

4. Module d'énergie solaire selon la revendication 1, comprenant en outre un troisième pont (33) qui connecte la pastille de réparation d'une autre cellule unitaire considérée comme étant défectueuse à la pastille de réparation d'une cellule unitaire adjacente considérée comme étant normale de sorte à définir par là même un circuit parallèle correspondant contournant l'autre cellule unitaire défectueuse dans ladite connexion en série des cellules unitaires successives.

5. Module d'énergie solaire selon la revendication 1, comprenant en outre :
une première ligne de sortie de module (93) qui est connectée à une première partie d'extrémité du conducteur de contournement; et
une seconde ligne de sortie de module (95) qui est connectée à une seconde partie d'extrémité du conducteur de contournement;
dans lequel les première et seconde lignes de sortie de module se prolongent dans une direction sensiblement orthogonale à une direction de prolongement du conducteur de contournement.

6. Module d'énergie solaire selon la revendication 5, dans lequel des première et seconde parties du conducteur de contournement sont connectées respectivement à la première et à la seconde ligne de sortie de module, et se connectent respectivement aux pastilles de réparation d'une cellule unitaire du module qui délivre en sortie la tension la plus élevée et d'une cellule unitaire du module qui délivre en sortie la tension la plus faible, et les première et seconde parties du conducteur de contournement sont respectivement séparées d'autres parties du conducteur de contournement.

7. Module d'énergie solaire selon la revendication 5, dans lequel chaque pastille de réparation se prolonge depuis la couche d'électrode inférieure de sa cellule unitaire respective.

8. Module d'énergie solaire selon la revendication 5, dans lequel chaque pastille de réparation se prolonge depuis la couche d'électrode supérieure.

9. Module d'énergie solaire selon la revendication 5, comprenant en outre :
un quatrième pont qui connecte la pastille de réparation d'une cellule unitaire défectueuse correspondante au conducteur de contournement; et
un cinquième pont qui connecte la pastille de réparation d'une cellule unitaire normale correspondante au conducteur de contournement;
dans lequel des pastilles de réparation de cellules adjacentes ne sont pas initialement connectées les unes aux autres, le quatrième et le cinquième ponts définissant par là même un contournement de circuit parallèle correspondant autour de la cellule unitaire défectueuse ou autour d'une ou plusieurs cellules unitaires défectueuses qui sont placées entre le quatrième et le cinquième pont dans ladite connexion en série des cellules unitaires successives.

10. Module d'énergie solaire selon la revendication 9, dans lequel une partie du conducteur de contournement qui connecte le quatrième pont au cinquième pont est séparée d'autres parties du conducteur de contournement.

11. Module d'énergie solaire selon la revendication 9, comprenant en outre un sixième pont qui connecte la pastille de réparation d'une cellule unitaire défectueuse à la pastille de réparation d'une cellule unitaire adjacente normale de sorte à définir par là même un circuit parallèle correspondant contournant la cellule unitaire défectueuse dans ladite connexion en série des cellules unitaires successives.

12. Module d'énergie solaire selon la revendication 5, dans lequel les pastilles de réparation des cellules unitaires successives sont fabriquées initialement de sorte à être connectées intégralement au conducteur de contournement et, après ladite fabrication initiale, une partie de séparation est formée sur les pastilles de réparation respectives de cellules unitaires considérées comme étant normales de sorte à séparer par là même électriquement les cellules unitaires normales du conducteur de contournement,

13. Module d'énergie solaire selon la revendication 12, dans lequel des parties du conducteur de contournement qui sont intégralement formées avec les pastilles de réparation de la cellule unitaire qui délivre en sortie une tension élevée et de la cellule unitaire qui délivre en sortie une tension faible sont séparées d'autres parties du conducteur de contournement.

14. Module d'énergie solaire selon la revendication 12, dans lequel la pastille de réparation d'une cellule unitaire normale qui se trouve à proximité d'un côté d'un ensemble défectueux d'une ou plusieurs cellules unitaires défectueuses successives est intégralement formée avec le conducteur de contournement, la partie de séparation est formée sur la pastille de réparation d'une cellule unitaire normale qui se trouve à proximité de l'autre côté de l'ensemble défectueux, de sorte que la ou les cellules unitaires défectueuses successives sont séparées électriquement de la connexion en série des cellules unitaires successives.

15. Module d'énergie solaire selon la revendication 14, dans lequel une partie du conducteur de contournement qui connecte la ou les cellules unitaires défectueuses successives les unes aux autres est séparée d'autres parties du conducteur de contournement.

16. Assemblage d'énergie solaire comprenant :
une pluralité de modules d'énergie solaire selon l'une quelconque des revendications précédentes ;
l'ensemble d'énergie solaire comprenant en outre :
une première ligne de contournement (71) qui se prolonge adjacente à la pastille de réparation de la cellule unitaire dont la sortie correspond à une sortie de haute tension de l'ensemble ;
une seconde ligne de contournement (75) qui se prolonge adjacente à la pastille de réparation de la cellule unitaire dont la sortie correspond à une sortie de basse tension de l'ensemble ;
une première ligne de sortie (93) connectant les pastilles de réparation respectives correspond à la sortie de haute tension des modules d'énergie solaire en parallèle les uns avec les autres ;
une seconde ligne de sortie (95) se connectant aux pastilles de réparation respectives correspond à la sortie de basse tension des modules d'énergie solaire en parallèle les uns avec les autres ;
un premier pont (35) connectant la première ligne de contournement à la pastille de réparation correspondant à la sortie de haute tension ; et
un deuxième pont (37) connectant la seconde ligne de contournement à la pastille de réparation correspondant à la sortie de basse tension.

17. Assemblage d'énergie solaire selon la revendication 16, dans lequel la première et la seconde ligne de sortie sont directement connectées aux pastilles de réparation qui correspondent à la sortie de haute tension et à la sortie de basse tension respectivement.

18. Assemblage d'énergie solaire selon la revendication 16, dans lequel la première ligne de sortie est directement connectée à la première ligne de contournement qui est connectée à la pastille de réparation correspondant à la sortie de haute tension ; et
la seconde ligne de sortie est directement connectée à la seconde ligne de contournement qui est connectée à la pastille de réparation correspondant à la sortie de basse tension.

19. Assemblage d'énergie solaire selon la revendication 16, dans lequel une partie de la première ligne de contournement qui est connectée à la pastille de réparation correspondant à la sortie de haute tension est séparée de l'autre de la première ligne de contournement; et
une partie de la seconde ligne de contournement qui est connectée à la pastille de réparation correspondant à la sortie de basse tension est séparée de l'autre de la seconde ligne de contournement.

20. Assemblage d'énergie solaire selon la revendication 16, dans lequel chaque pastille de réparation se prolonge depuis la couche d'électrode inférieure de sa cellule unitaire respective.

21. Assemblage d'énergie solaire selon la revendication 16, dans lequel chaque pastille de réparation se prolonge depuis la couche d'électrode supérieure.

22. Assemblage d'énergie solaire selon la revendication 16, dans lequel le nombre des cellules unitaires qui sont placées entre la sortie de haute tension et la sortie de basse tension est déterminé de telle sorte que des tensions de sortie de module respectives des modules d'énergie solaire, qu'ils soient réglés ou non, soient essentiellement identiques les unes aux autres.

23. Assemblage d'énergie solaire selon la revendication 22, comprenant en outre un troisième pont qui connecte directement les pastilles de réparation de cellules unitaires adjacentes les unes aux autres.

24. Assemblage d'énergie solaire selon la revendication 23, dans lequel au moins une des pastilles de réparation qui sont connectées les unes aux autres par le troisième pont (33) est une pastille de réparation d'une cellule unitaire défectueuse.

25. Assemblage d'énergie solaire selon la revendication 22, dans lequel au moins un des modules d'énergie solaire comprend en outre au moins un d'un quatrième pont et d'un cinquième pont, le quatrième pont connectant directement une première pastille de réparation à la première ligne de contournement, et le cinquième pont connectant directement une seconde pastille de réparation à la seconde ligne de contournement.

26. Assemblage d'énergie solaire selon la revendication 25, dans lequel au moins une des premières pastilles de réparation qui est connectée à la première ligne de contournement par une pluralité des quatrièmes ponts respectivement est une pastille de réparation d'une cellule unitaire défectueuse, et
au moins une des secondes pastilles de réparation qui est connectée à la seconde ligne de contournement par une pluralité des cinquièmes ponts respectivement est une pastille de réparation d'une cellule unitaire défectueuse.

27. Procédé de réparation ou de réglage d'un module d'énergie solaire, du module d'énergie solaire selon la revendication 1, dans lequel la couche d'électrode supérieure (15) qui est placée sur une ou plusieurs couches correspondantes des couches semi-conductrices de chaque cellule unitaire où les couches semi-conductrices définissent un convertisseur photoélectrique et la couche d'électrode supérieure d'une première des cellules sont connectées électriquement à une couche d'électrode inférieure (11) sous des couches semi-conductrices (20) d'une cellule unitaire adjacente suivante dans une première direction, de sorte que les cellules unitaires successives sont par là même connectées en série les unes avec les autres, le procédé comprenant : au moins une de l'exécution d'un premier contournement et de l'exécution d'un second contournement;
dans lequel ladite exécution du premier contournement consiste à connecter des pastilles de réparation (30) qui se prolongent depuis les couches d'électrode d'une première cellule unitaire et d'une deuxième cellule unitaire à une ligne de contournement de telle sorte qu'une ou plusieurs cellules unitaires incluant la première cellule unitaire ou la deuxième cellule unitaire sont contournées, et
dans lequel ladite exécution du second contournement consiste à connecter directement des pastilles de réparation d'une troisième cellule unitaire et d'une quatrième cellule unitaire les unes aux autres de telle sorte qu'au moins une de la troisième cellule unitaire et de la quatrième cellule soit contournée, et dans lequel ladite connexion des pastilles de réparation les unes aux autres ou à la ligne de contournement inclut la formation d'un pont de pastille à pastille (33) ou d'un pont de pastille à contournement (35, 37).

28. Procédé de réparation ou de réglage d'un module d'énergie solaire selon la revendication 27, dans lequel l'exécution du premier contournement et du second contournement consiste à connecter électriquement une pastille de réparation qui se prolonge depuis l'électrode inférieure d'une cellule unitaire défectueuse à une pastille de réparation qui se prolonge depuis l'électrode inférieure d'une cellule unitaire adjacente suivante dans la première direction.

29. Procédé selon la revendication 27, dans lequel l'exécution du premier contournement et du second contournement connecte électriquement une pastille de réparation qui se prolonge depuis l'électrode supérieure d'une cellule unitaire défectueuse à une pastille de réparation qui se prolonge depuis l'électrode supérieure d'une cellule unitaire adjacente suivante dans la direction opposée à la première direction.

30. Procédé selon la revendication 27, dans lequel l'exécution du premier contournement consiste en outre à séparer une partie d'une ligne de contournement qui connecte les pastilles de réparation des première et deuxième cellules unitaires de l'autre de la ligne de contournement.

31. Procédé selon la revendication 27, consistant en outre :
à séparer une ligne de sortie de module de la pastille de réparation d'une première cellule unitaire périphérique de l'ensemble ;
à connecter la ligne de sortie de module à une section d'extrémité de la ligne de contournement; et
à séparer une partie de la ligne de contournement qui est connectée à la ligne de sortie, d'une autre partie de la ligne de contournement.

32. Procédé de réparation d'un module d'énergie solaire selon la revendication 1, une couche d'électrode supérieure (15) qui est placée sur une ou plusieurs couches semi-conductrices de la cellule unitaire définissant un convertisseur photoélectrique est connecté électriquement à une couche d'électrode inférieure (11) sous des couches semi-conductrices (20) d'une cellule unitaire adjacente suivante dans une première direction, de sorte que les cellules unitaires successives sont connectées en série les unes aux autres, le procédé consistant :
à séparer la pastille de réparation (30) qui se prolonge depuis une couche d'électrode d'une cellule unitaire normale et qui est initialement intégralement formée avec une ligne de contournement (70), de la ligne de contournement; et
à séparer une partie de la ligne de contournement (70) qui est initialement intégralement formée avec une cellule unitaire défectueuse, de l'autre de la ligne de contournement.

33. Procédé de réparation d'un module d'énergie solaire selon la revendication 32, dans lequel la pastille de réparation qui se prolonge depuis l'électrode inférieure de la cellule unitaire normale suivante adjacente à la cellule unitaire défectueuse dans la première direction n'est pas séparée de la ligne de contournement mais est maintenue de sorte à être initialement dans un état où elle est intégralement formée.

34. Procédé de réparation d'un module d'énergie solaire selon la revendication 32, dans lequel la pastille de réparation qui se prolonge depuis l'électrode supérieure de la cellule unitaire normale suivante adjacente à la cellule unitaire défectueuse dans la direction opposée à la première direction n'est pas séparée de la ligne de contournement mais est maintenue de sorte à être initialement dans un état où elle est intégralement formée.

35. Procédé de réparation d'un module d'énergie solaire selon la revendication 32, consistant en outre à séparer une partie de la ligne de contournement, la partie de la ligne de contournement qui est intégralement formée avec la pastille de réparation correspondant à une sortie de tension de l'ensemble et étant connectée à une ligne de sortie du module d'énergie solaire.

36. Procédé de réglage d'un assemblage d'énergie solaire, l'assemblage d'énergie solaire selon la revendication 16, dans lequel la couche d'électrode supérieure (15) est placée sur une ou plusieurs des couches semi-conductrices (20) correspondantes de chaque cellule unitaire, le procédé consistant :
à définir une tension qui doit être essentiellement délivrée en sortie par la totalité des modules d'énergie solaire de l'assemblage en tant que tension de sortie de référence ;
à dériver, où il est nécessaire, une ou plusieurs cellules dans chacun des modules d'énergie solaire de façon à amener ainsi chacun à avoir la tension de sortie de référence ; et
à connecter en parallèle des sorties de tensions respectives des modules d'énergie solaire les unes aux autres au moyen de lignes de sortie des modules d'énergie solaire, dans lequel la connexion parallèle de sorties de tensions respectives consiste :
à connecter une pastille de réparation d'une cellule unitaire supérieure à une première ligne de contournement qui est connectée à une première ligne de sortie de chaque module d'énergie solaire, pour que la cellule unitaire supérieure du nombre sélectionné de cellules unitaires pour le module d'énergie solaire ait une tension de sortie qui est sensiblement la même que la tension de sortie de référence ; et
à connecter une pastille de réparation d'une cellule unitaire inférieure du nombre sélectionné de cellules unitaires à une seconde ligne de contournement qui est connectée à une seconde ligne de sortie de chaque module d'énergie solaire, et dans lequel la connexion des pastilles de réparation les unes aux autres ou à la ligne de contournement inclut la formation d'un pont de pastille à pastille (33) ou d'un pont de pastille à contournement (35, 37).

37. Procédé de réglage d'un assemblage d'énergie solaire selon la revendication 36, dans lequel la définition de la tension de sortie de référence consiste :
à détecter des tensions de sortie unitaires des cellules unitaires du module d'énergie solaire au moyen d'une sonde ; et
à déterminer la tension de sortie de module de chaque module d'énergie solaire comme étant le total des tensions de sortie unitaires détectées de ses cellules unitaires.

38. Procédé de réglage d'un assemblage d'énergie solaire selon la revendication 37, dans lequel la connexion parallèle de sorties de tension respectives consiste :
à connecter une première ligne de sortie de chaque module d'énergie solaire les unes aux autres, chacune des premières lignes de sortie (93) étant directement connectée à une pastille de réparation d'une cellule unitaire supérieure dont la sortie correspond à une sortie de haute tension de l'ensemble ; et
à connecter une seconde ligne de sortie (95) de chaque module d'énergie solaire les unes aux autres, chacune des secondes lignes de sortie étant directement connectée à une pastille de réparation d'une cellule unitaire inférieure dont la sortie correspond à une sortie de basse tension de l'ensemble.

39. Procédé de réglage d'un assemblage d'énergie solaire selon la revendication 36, dans lequel la connexion parallèle de sorties de tension respectives consiste en outre :
à séparer une partie de la première ligne de contournement qui connecte la pastille de réparation de la cellule unitaire supérieure à la première ligne de sortie de l'autre de la première ligne de contournement; et
à séparer une partie de la seconde ligne de contournement qui connecte la pastille de réparation de la cellule unitaire inférieure à la seconde ligne de sortie de l'autre de la seconde ligne de contournement.

40. Procédé de réglage d'un assemblage d'énergie solaire selon la revendication 37, dans lequel la réparation de chacun des modules d'énergie solaire consiste à dériver au moins une cellule unitaire d'au moins un module d'énergie solaire.

41. Procédé de réglage d'un assemblage d'énergie solaire selon la revendication 37, dans lequel le contournement d'au moins une cellule unitaire comprend au moins l'un d'une exécution d'un premier contournement et d'une exécution d'un second contournement,
l'exécution du premier contournement incluant la connexion de pastilles de réparation qui se prolongent depuis des couches d'électrode d'une première cellule unitaire et d'une deuxième cellule unitaire à une ligne de contournement de telle sorte qu'une ou plusieurs cellules unitaires incluant la première cellule unitaire ou la deuxième cellule unitaire sont contournées, et
l'exécution du second contournement incluant la connexion directe de pastilles de réparation d'une troisième cellule unitaire et d'une quatrième cellule unitaire les unes aux autres de telle sorte qu'au moins une de la troisième cellule unitaire et la quatrième cellule unitaire soient contournées.
